# EUROPEAN PATENT SPECIFICATION

(11) **EP 4 391 372 B1**
(45) Date of publication and mention of the grant of the patent: **29.10.2025**
(21) Application number: 21954613.2
(22) Date of filing: 27.08.2021
(51) Int. Cl.: H03F 1/32, H03F 3/189, H04B 1/04, H03F 3/24

(54) **SIGNAL AMPLIFICATION CIRCUIT AND METHOD, AND SIGNAL TRANSMITTER**
SIGNALVERSTÄRKUNGSSCHALTUNG UND -VERFAHREN UND SIGNALSENDER
CIRCUIT ET PROCÉDÉ D'AMPLIFICATION DE SIGNAL, ET ÉMETTEUR DE SIGNAL

(43) Date of publication of application: 26.06.2024
(73) Proprietor: Huawei Technologies Co., Ltd., Shenzhen, Guangdong 518129 (CN)
(72) Inventor: TANG, Haizheng, Shenzhen, Guangdong 518129 (CN); LV, Jia, Shenzhen, Guangdong 518129 (CN); XIAO, Yuxiang, Shenzhen, Guangdong 518129 (CN); WEI, Hongliang, Shenzhen, Guangdong 518129 (CN); LI, Jing, Shenzhen, Guangdong 518129 (CN)
(74) Representative: Grünecker Patent- und Rechtsanwälte PartG mbB
(86) International application number: PCT/CN2021/115088
(87) International publication number: WO 2023/024090

(56) References cited:
- CN-A- 1 374 812
- CN-A- 1 390 063
- CN-A- 1 411 147
- CN-A- 103 219 957
- CN-A- 103 312 274
- CN-A- 105 515 592
- CN-A- 108 390 651
- CN-A- 112 615 632
- US-A- 5 770 971
- US-A1- 2002 084 847
- US-A1- 2016 191 020
- US-B1- 6 188 732
- US-B2- 6 934 341
- BURGLECHNER S ET AL: "DSP oriented implementation of a feedforward power amplifier linearizer", CIRCUITS AND SYSTEMS, 2009. ISCAS 2009. IEEE INTERNATIONAL SYMPOSIUM ON, IEEE, PISCATAWAY, NJ, USA, 24 May 2009 (2009-05-24), pages 1755 - 1758, XP031606866, ISBN: 978-1-4244-3827-3

## Description

### TECHNICAL FIELD

This application relates to the field of electronic technologies, and in particular, to a signal amplification circuit and method, and a signal transmitter.

### BACKGROUND

A radio frequency signal transmitter generally includes a power amplifier and a transmit antenna. The power amplifier is configured to amplify power of a to-be-sent signal, to ensure that the signal can be fed to the transmit antenna for radiation.

However, when amplifying the signal, the power amplifier causes nonlinear distortion of an amplified signal, and a background noise in the signal is also amplified, resulting in serious distortion of the amplified signal.

US6188732B1, US2002/084847A1 and US6934341B2 as well as BURGLECHNER S ET AL: "DSP oriented implementation of a feedforward power amplifier linearizer", ISCAS 2009, 24 May 2009, pages 1755-1758, XP031606866, present related art solutions.

### SUMMARY

This application provides a signal amplification circuit and method, and a signal transmitter, to resolve a technical problem in a conventional technology that a power-amplified signal is nonlinearly distorted and a background noise is serious.

According to one aspect, a signal amplification circuit is provided. The signal amplification circuit includes a signal amplification sub-circuit, a first signal extraction sub-circuit, a second signal extraction sub-circuit, and a distorted signal cancellation sub-circuit, where the signal amplification sub-circuit is configured to perform digital-to-analog conversion and power amplification on a first digital signal to obtain a first analog signal; the first signal extraction sub-circuit is configured to: perform amplitude modulation and/or phase modulation on the first digital signal, perform digital-to-analog conversion on an amplitude-modulated and/or phase-modulated first digital signal to obtain a second analog signal, and couple the second analog signal and the first analog signal to obtain a first distorted signal; the second signal extraction sub-circuit is configured to: perform analog-to-digital conversion on the first distorted signal, perform amplitude modulation and/or phase modulation on the first digital signal, and couple a first distorted signal obtained through the analog-to-digital conversion and an amplitude-modulated and/or phase-modulated first digital signal to obtain a second distorted signal; and the distorted signal cancellation sub-circuit is configured to: perform digital-to-analog conversion on the second distorted signal to obtain a third distorted signal, and couple the third distorted signal and the first analog signal to obtain an output signal.

The signal amplification circuit provided in this application can successively extract the distorted signal in an analog domain and a digital domain, so that it can be ensured that a residual of a main signal in the extracted distorted signal is small. Therefore, it can be ensured that after the distorted signal is coupled to the first analog signal, the distorted signal (where the distorted signal includes a nonlinear signal and a background noise) in the first analog signal can be effectively cancelled, thereby effectively improving linearity of the output signal that is finally output.

Optionally, the first signal extraction sub-circuit is configured to sequentially perform digital-to-analog conversion, power amplification, and bandpass filtering on the amplitude-modulated and/or phase-modulated first digital signal to obtain the second analog signal, where a filtering passband of the bandpass filtering is greater than or equal to an operating frequency band of the output signal.

Because power of the amplitude-modulated and/or phase-modulated first digital signal is low, the amplitude-modulated and/or phase-modulated first digital signal needs to be converted into an analog signal and power amplification needs to be performed, to ensure that an amplitude of a main signal in the second analog signal is as equal as possible to an amplitude of a main signal in the first analog signal, thereby ensuring that the main signal is effectively cancelled. Bandpass filtering is performed on a signal obtained through the digital-to-analog conversion and the power amplification, so that a distorted signal outside an operating frequency band of the main signal can be effectively filtered out.

Optionally, the first signal extraction sub-circuit includes a first amplitude and phase modulator, a first digital-to-analog converter (digital to analog converter, DAC), a first amplifier (amplifier, AMP), a bandpass filter, and a first combiner that are sequentially connected, where the first amplitude and phase modulator is configured to perform amplitude modulation and/or phase modulation on the first digital signal; the first digital-to-analog converter is configured to perform digital-to-analog conversion on an amplitude-modulated and/or phase-modulated first digital signal output by the first amplitude and phase modulator; the first amplifier is configured to perform power amplification on a signal output by the first digital-to-analog converter; the bandpass filter is configured to perform bandpass filtering on a signal output by the first amplifier to obtain the second analog signal; and the first combiner is further connected to the signal amplification sub-circuit, and the first combiner is configured to couple the second analog signal and the first analog signal to obtain the first distorted signal.

The first signal extraction sub-circuit may cancel the main signal in the first analog signal in the analog domain, to extract the first distorted signal in the first analog signal.

Optionally, the first signal extraction sub-circuit further includes a nonlinear signal analog device and a second digital-to-analog converter, where the nonlinear signal analog device is configured to generate a nonlinear signal based on the first digital signal; the second digital-to-analog converter is separately connected to the nonlinear signal analog device and the first combiner, and the second digital-to-analog converter is configured to perform digital-to-analog conversion on the nonlinear signal; and the first combiner is configured to couple the second analog signal, the first analog signal, and a nonlinear signal obtained through the digital-to-analog conversion to obtain the first distorted signal.

The nonlinear signal generated by the nonlinear signal analog device may also be referred to as an intermodulation distortion signal or a remote lower-order nonlinear signal. When the first digital signal is a dual-band signal, intermodulation distortion occurs after power amplification is performed on the dual-band signal. The nonlinear analog device may analogously output the intermodulation distortion in the digital domain. Correspondingly, after the nonlinear signal and the second analog signal are coupled to the first analog signal, not only the main signal in the first analog signal can be cancelled, but also an intermodulation distortion signal in the first analog signal can be effectively cancelled.

Optionally, the second signal extraction sub-circuit includes a second amplitude and phase modulator, an analog-to-digital converter (analog-to-digital converter, ADC), and a second combiner, where the second amplitude and phase modulator is configured to perform amplitude modulation and/or phase modulation on the first digital signal; the analog-to-digital converter is connected to the first signal extraction sub-circuit, and the analog-to-digital converter is configured to perform analog-to-digital conversion on the first distorted signal; and the second combiner is separately connected to the second amplitude and phase modulator and the analog-to-digital converter, and the second combiner is configured to couple a first distorted signal obtained through the analog-to-digital conversion and an amplitude-modulated and/or phase-modulated first digital signal to obtain the second distorted signal.

It may be understood that, the residual of the main signal may be in the first distorted signal, and the first distorted signal obtained through the analog-to-digital conversion is coupled to the amplitude-modulated and/or phase-modulated first digital signal, so that the residual main signal in the first distorted signal can be effectively cancelled. In addition, because analog-to-digital conversion is performed on the first distorted signal output by the first signal extraction sub-circuit to convert the first distorted signal into a digital signal, the second combiner can extract the distorted signal in the digital domain, so that the main signal is better cancelled. In addition, if the first combiner can further cancel the intermodulation distortion signal in the first analog signal, it can be ensured that a power change range of the output first distorted signal is small, thereby reducing a requirement on a dynamic range of the analog-to-digital converter.

Optionally, the signal amplification circuit further includes a first signal processor separately connected to the second combiner and the second amplitude and phase modulator, where the first signal processor is configured to adjust an amplitude and phase modulation parameter of the second amplitude and phase modulator based on an error between the second distorted signal and the first digital signal.

The first signal processor adjusts the amplitude and phase modulation parameter of the second amplitude and phase modulator, so that when the amplitude-modulated and/or phase-modulated first digital signal output by the second amplitude and phase modulator is coupled to the first distorted signal obtained through the analog-to-digital conversion, the residual main signal in the first distorted signal can be effectively cancelled.

Optionally, the distorted signal cancellation sub-circuit includes a third amplitude and phase modulator, a third digital-to-analog converter, a second amplifier, a third combiner, and a delayer that are sequentially connected, where the third amplitude and phase modulator is further connected to the second signal extraction sub-circuit, and the third amplitude and phase modulator is configured to perform amplitude modulation and/or phase modulation on the second distorted signal; the third digital-to-analog converter is configured to perform digital-to-analog conversion on an amplitude-modulated and/or phase-modulated second distorted signal output by the third amplitude and phase modulator to obtain the third distorted signal; the second amplifier is configured to perform power amplification on the third distorted signal; the delayer is further connected to the signal amplification sub-circuit, and the delayer is configured to delay the first analog signal and then transmit the first analog signal to the third combiner; and the third combiner is configured to couple a power-amplified third distorted signal and the delayed first analog signal to obtain the output signal.

The delayer delays the first analog signal, to ensure that the first analog signal and the power-amplified third distorted signal can be simultaneously transmitted to the third combiner, thereby ensuring that the distorted signal in the first analog signal can be effectively cancelled.

Optionally, the distorted signal cancellation sub-circuit further includes an isolator separately connected to the second amplifier and the third combiner, where the isolator is configured to isolate a signal transmitted from the third combiner to the second amplifier.

Because the isolator can prevent the third combiner from reversely outputting the first analog signal to the second amplifier, the signal reversely output by the third combiner may be prevented from affecting working performance of the second amplifier.

Optionally, the signal amplification circuit further includes a second signal processor separately connected to the third combiner and the third amplitude and phase modulator, where the second signal processor is configured to adjust an amplitude and phase modulation parameter of the third amplitude and phase modulator based on an error between the output signal and the first digital signal.

The second signal processor adjusts the amplitude and phase modulation parameter of the third amplitude and phase modulator, so that an amplitude of the third distorted signal obtained based on the second distorted signal is as equal as possible to an amplitude of the distorted signal in the first analog signal transmitted by the signal amplification sub-circuit to the third combiner, and a phase of the third distorted signal is as same as or opposite to a phase of the distorted signal in the first analog signal transmitted by the signal amplification sub-circuit to the third combiner as possible. Correspondingly, it can be ensured that a distorted signal in the output signal output by the third combiner can be effectively cancelled.

In another aspect, a signal amplification method is provided. The signal amplification method includes: performing digital-to-analog conversion and power amplification on a first digital signal to obtain a first analog signal; performing amplitude modulation and/or phase modulation on the first digital signal, and performing digital-to-analog conversion on an amplitude-modulated and/or phase-modulated first digital signal to obtain a second analog signal; coupling the second analog signal and the first analog signal to obtain a first distorted signal; performing analog-to-digital conversion on the first distorted signal; coupling a first distorted signal obtained through the analog-to-digital conversion and an amplitude-modulated and/or phase-modulated first digital signal to obtain a second distorted signal; performing digital-to-analog conversion on the second distorted signal to obtain a third distorted signal; and coupling the third distorted signal and the first analog signal to obtain an output signal.

Optionally, the performing digital-to-analog conversion on an amplitude-modulated and/or phase-modulated first digital signal to obtain a second analog signal includes: sequentially performing digital-to-analog conversion, power amplification, and bandpass filtering on the amplitude-modulated and/or phase-modulated first digital signal to obtain the second analog signal, where a filtering passband of the bandpass filtering is greater than or equal to an operating frequency band of the output signal.

Optionally, the performing digital-to-analog conversion on an amplitude-modulated and/or phase-modulated first digital signal to obtain a second analog signal further includes: generating a nonlinear signal based on the first digital signal; and performing digital-to-analog conversion on the nonlinear signal. The coupling the second analog signal and the first analog signal to obtain a first distorted signal includes: coupling the second analog signal, the first analog signal, and a nonlinear signal obtained through the digital-to-analog conversion to obtain the first distorted signal.

Optionally, based on an error between the second distorted signal and the first digital signal, an amplitude and phase modulation parameter used when amplitude modulation and/or phase modulation is performed on the first digital signal is adjusted.

An amplitude and phase modulation parameter of a second amplitude and phase modulator is adjusted based on the error between the second distorted signal and the first digital signal, to adjust an adjustment degree of an amplitude and/or a phase of the first digital signal performed by the second amplitude and phase modulator. In this way, it can be ensured that when the amplitude-modulated and/or phase-modulated first digital signal is coupled to the first distorted signal obtained through the analog-to-digital conversion, a residual main signal in the first distorted signal can be effectively cancelled.

Optionally, the performing digital-to-analog conversion on the second distorted signal to obtain a third distorted signal includes: performing amplitude modulation and/or phase modulation on the second distorted signal; and performing digital-to-analog conversion on an amplitude-modulated and/or phase-modulated second distorted signal to obtain the third distorted signal, where the coupling the third distorted signal and the first analog signal to obtain an output signal including: performing power amplification on the third distorted signal; delaying the first analog signal; and coupling a power-amplified third distorted signal and the delayed first analog signal to obtain the output signal.

Optionally, the coupling a power-amplified third distorted signal and the delayed first analog signal to obtain the output signal further includes: adjusting, based on an error between the output signal and the first digital signal, an amplitude and phase modulation parameter used when amplitude modulation and/or phase modulation is performed on the second distorted signal.

According to still another aspect, a signal transmitter is provided. The signal transmitter includes a signal generation circuit and the signal amplification circuit provided in the foregoing aspects, where the signal generation circuit is connected to the signal amplification circuit, and the signal generation circuit is configured to transmit a first digital signal to the signal amplification circuit.

In conclusion, the present invention provides a signal amplification circuit and method, and a signal transmitter. According to the solutions provided in the present invention, digital-to-analog conversion and power amplification can be performed on the first digital signal to obtain the first analog signal, the distorted signal in the first analog signal can be extracted in the analog domain and the digital domain separately, and the extracted distorted signal is coupled to the first analog signal to obtain the output signal. Because the signal amplification circuit can successively extract the distorted signal in the analog domain and the digital domain, it can be ensured that the residual of the main signal in the extracted distorted signal is small. Therefore, it can be ensured that after the distorted signal is coupled to the first analog signal, the distorted signal in the first analog signal can be effectively cancelled, thereby effectively improving the linearity of the output signal that is finally output.

### BRIEF DESCRIPTION OF DRAWINGS

FIG. 1 is a schematic diagram of a structure of a signal amplification circuit according to an embodiment of this application;
FIG. 2 is a schematic diagram of a structure of another signal amplification circuit according to an embodiment of this application;
FIG. 3 is a schematic diagram in which a bandpass filter filters an analog signal output by a first amplifier according to an embodiment of this application;
FIG. 4 is a schematic diagram of coupling a second analog signal and a first analog signal by a first combiner according to an embodiment of this application;
FIG. 5 is a schematic diagram of a structure of still another signal amplification circuit according to an embodiment of this application;
FIG. 6 is a schematic diagram in which a second combiner couples a first distorted signal obtained through digital-to-analog conversion and an amplitude-modulated and/or phase-modulated first digital signal according to an embodiment of this application;
FIG. 7 is a schematic diagram of coupling a third distorted signal and a first analog signal by a third combiner according to an embodiment of this application;
FIG. 8 is a flowchart of a signal amplification method according to an embodiment of this application;
FIG. 9 is a flowchart of another signal amplification method according to an embodiment of this application; and
FIG. 10 is a schematic diagram of a structure of a signal transmitter according to an embodiment of this application;

### DESCRIPTION OF EMBODIMENTS

To make the objectives, technical solutions, and advantages of this application clearer, the following further describes implementations of this application in detail with reference to the accompanying drawings.

When a power amplifier (power amplifier, PA) in a radio frequency signal transmitter amplifies a signal, nonlinear distortion occurs on an amplified signal. Generally, a digital forward feedback cancelation (digital forward feedback cancelation, DFFC) technology may be used for cancelling the nonlinear distortion.

In the DFFC technology, digital-to-analog conversion and power amplification may be performed on an input digital signal to obtain a first channel of analog signals, and amplitude modulation and phase modulation and digital-to-analog conversion may be performed on the input digital signal to obtain a second channel of analog signals. Then, the two channels of analog signals may be coupled to extract a nonlinear signal in the first channel of analog signals, or that the two channels of analog signals may be coupled to extract a nonlinear signal in the first channel of analog signals may be understood as that fitting of the nonlinear signal in the first channel of analog signals is implemented. Finally, an amplitude-modulated and/or phase-modulated nonlinear signal may be coupled to the first channel of analog signals, to alleviate nonlinear distortion of the first channel of analog signals.

However, in the foregoing DFFC technology, the nonlinear signal is extracted in an analog domain, and consequently, fitting precision of the nonlinear signal is limited. As a result, there are still a plurality of residual nonlinear signals in a first channel of coupled analog signals. In other words, a degree of alleviating the nonlinear distortion in the first channel of analog signals is limited.

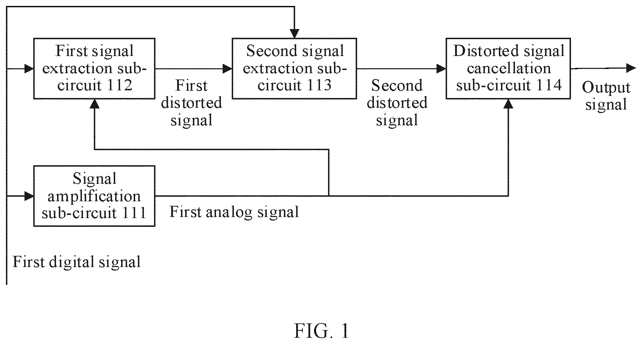

FIG. 1 is a schematic diagram of a structure of a signal amplification circuit according to an embodiment of this application. Refer to FIG. 1. The signal amplification circuit provided in this embodiment of this application includes a signal amplification sub-circuit 111, a first signal extraction sub-circuit 112, a second signal extraction sub-circuit 113, and a distorted signal cancellation sub-circuit 114.

The signal amplification sub-circuit 111 is configured to perform digital-to-analog conversion and power amplification on a first digital signal to obtain a first analog signal.

The first signal extraction sub-circuit 112 is connected to an output end of the signal amplification sub-circuit 111. The first signal extraction sub-circuit 112 is configured to: perform amplitude modulation and/or phase modulation on the first digital signal, perform digital-to-analog conversion on an amplitude-modulated and/or phase-modulated first digital signal to obtain a second analog signal, and couple the second analog signal and the first analog signal output by the signal amplification sub-circuit 111 to obtain a first distorted signal.

It may be understood that, because nonlinear distortion and linear distortion are generated when the signal amplification sub-circuit 111 performs power amplification on a first digital signal obtained through the digital-to-analog conversion, the first analog signal not only includes a main signal, but also includes a nonlinear signal generated due to the nonlinear distortion and a noise signal generated due to the linear distortion. The nonlinear signal and the noise signal may be collectively referred to as a distorted signal. The nonlinear signal may also be referred to as a nonlinear component, and the noise signal may also be referred to as a background noise or a thermal noise. The main signal is a signal obtained by performing, by a power amplifier in an ideal situation, power amplification on a first digital signal obtained through analog-to-digital conversion, that is, a signal output by the power amplifier when there is no nonlinear distortion or linear distortion.

After coupling the second analog signal and the first analog signal, the first signal extraction sub-circuit 112 may extract the nonlinear component and the background noise, namely, the first distorted signal, in the first analog signal. In other words, the first signal extraction sub-circuit 112 can extract, in an analog domain, the nonlinear component and the background noise in the first analog signal.

The second signal extraction sub-circuit 113 is connected to an output end of the first signal extraction sub-circuit 112. The second signal extraction sub-circuit 113 is configured to: perform analog-to-digital conversion on the first distorted signal, perform amplitude modulation and/or phase modulation on the first digital signal, and couple a first distorted signal obtained through the analog-to-digital conversion and an amplitude-modulated and/or phase-modulated first digital signal to obtain a second distorted signal.

It may be understood that the first distorted signal extracted by the first signal extraction sub-circuit 112 may have a residual main signal. The second signal extraction sub-circuit 113 can further extract, in a digital domain, a nonlinear component and a background noise, namely, the second distorted signal, in the first distorted signal. Alternatively, it may be understood as that the second signal extraction sub-circuit 113 can cancel, in the digital domain, the residual main signal in the first distorted signal.

The distorted signal cancellation sub-circuit 114 is connected to an output end of the second signal extraction sub-circuit 113. The distorted signal cancellation sub-circuit 114 is configured to: perform digital-to-analog conversion on the second distorted signal to obtain a third distorted signal, and couple the third distorted signal and the first analog signal to obtain an output signal.

Based on the foregoing analysis, it can be learned that the second distorted signal is a signal obtained by extracting the nonlinear component and the background noise in the first analog signal in the analog domain and the digital domain separately. Therefore, after a second distorted signal obtained through the digital-to-analog conversion (namely, the third distorted signal) is coupled to the first analog signal, the nonlinear component and the background noise in the first analog signal can be effectively reduced. This effectively improves linearity of the output signal.

It should be understood that, in an ideal situation, when the signal amplification sub-circuit 111 performs power amplification on the first digital signal obtained through the digital-to-analog conversion, amplitude gains of a power-amplified signal at all frequencies are the same, and a phase also changes linearly. However, because it is difficult for the signal amplification sub-circuit 111 to work in the ideal situation, the amplitude gains of the power-amplified signal at different frequencies are different, and the phase does not change nonlinearly. Therefore, it is difficult to well cancel the main signal in the first analog signal in the analog domain. In the solution provided in this embodiment of this application, the second signal extraction sub-circuit 113 can perform amplitude and phase modulation on the first digital signal in the digital domain, so that an amplitude of the amplitude-modulated and/or phase-modulated first digital signal approximates an amplitude of the residual main signal in the first distorted signal, and a phase of the amplitude-modulated and/or phase-modulated first digital signal also approximates a phase of the residual main signal in the first distorted signal. Therefore, the main signal in the first analog signal can be better cancelled.

In conclusion, this embodiment of this application provides a signal amplification circuit. After performing digital-to-analog conversion and power amplification on the first digital signal to obtain the first analog signal, the signal amplification circuit may extract the distorted signal in the first analog signal in the analog domain and the digital domain separately, and couple the extracted distorted signal and the first analog signal to obtain the output signal. Because the signal amplification circuit can successively extract the distorted signal in the analog domain and the digital domain, it can be ensured that a residual of the main signal in the extracted distorted signal is small. Therefore, it can be ensured that after the distorted signal is coupled to the first analog signal, the distorted signal in the first analog signal can be effectively cancelled, thereby effectively improving the linearity of the output signal that is finally output.

Optionally, the first signal extraction sub-circuit 112 may be configured to sequentially perform digital-to-analog conversion, power amplification, and bandpass filtering on the amplitude-modulated and/or phase-modulated first digital signal to obtain the second analog signal, where a filtering passband of the bandpass filtering is greater than or equal to an operating frequency band of the output signal.

The first signal extraction sub-circuit 112 may obtain an initial analog signal after sequentially performing digital-to-analog conversion and power amplification on the amplitude-modulated and/or phase-modulated first digital signal. A distorted signal also exists in the initial analog signal, and a distorted signal outside a filtering passband can be effectively filtered out by performing bandpass filtering on the initial analog signal.

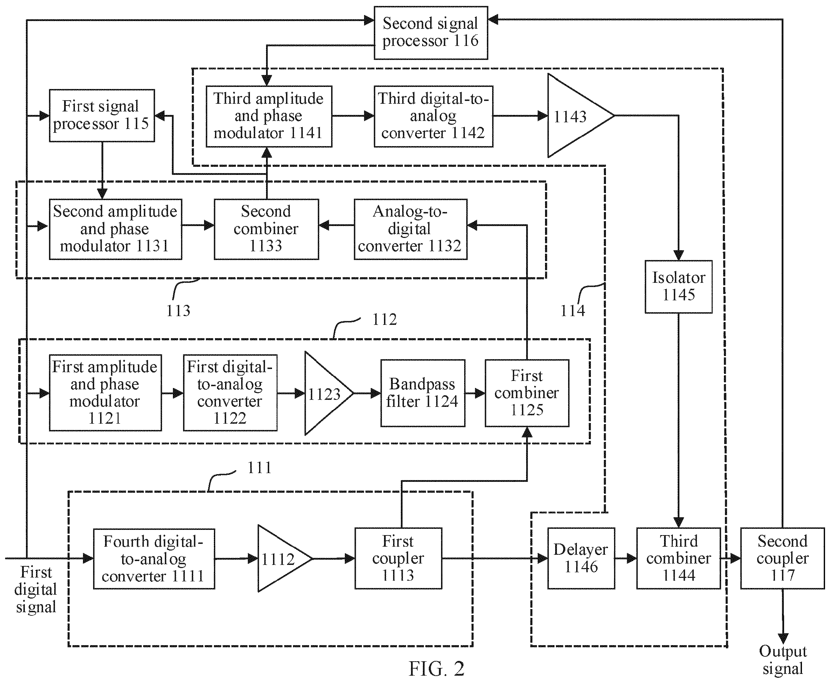

FIG. 2 is a schematic diagram of a structure of another signal amplification circuit according to an embodiment of this application. Refer to FIG. 2. A first signal extraction sub-circuit 112 may include a first amplitude and phase modulator 1121, a first digital-to-analog converter 1122, a first amplifier 1123, a bandpass filter 1124, and a first combiner 1125. The foregoing components may be sequentially connected by using a signal cable.

As shown in FIG. 2, the first amplitude and phase modulator 1121 is configured to perform amplitude modulation and/or phase modulation on a first digital signal.

The first amplitude and phase modulator 1121 may increase an amplitude of the first digital signal, and/or reverse a phase of the first digital signal. To be specific, the first amplitude and phase modulator 1121 may only increase the amplitude of the first digital signal, or only reverse the phase of the first digital signal, or may not only increase the amplitude of the first digital signal, but also reverse the phase of the first digital signal.

The first digital-to-analog converter 1122 is configured to perform digital-to-analog conversion on an amplitude-modulated and/or phase-modulated first digital signal output by the first amplitude and phase modulator 1121 to convert the amplitude-modulated and/or phase-modulated first digital signal into an analog signal.

The first amplifier 1123 is configured to perform power amplification on the signal output by the first digital-to-analog converter 1122.

Because power of the amplitude-modulated and/or phase-modulated first digital signal output by the first amplitude and phase modulator 1121 is low, power amplification needs to be performed, by the first amplifier 1123, on the signal output by the first digital-to-analog converter 1122. Therefore, power of a second analog signal loaded to the first combiner 1125 may be approximately equal to power of a first analog signal loaded by a signal amplification sub-circuit 111 to the first combiner 1125. This ensures that a main signal in the first analog signal can be effectively cancelled.

The bandpass filter 1124 is configured to perform bandpass filtering on a signal output by the first amplifier 1123 to obtain the second analog signal. A filtering passband of the bandpass filtering is greater than or equal to an operating frequency band of an output signal.

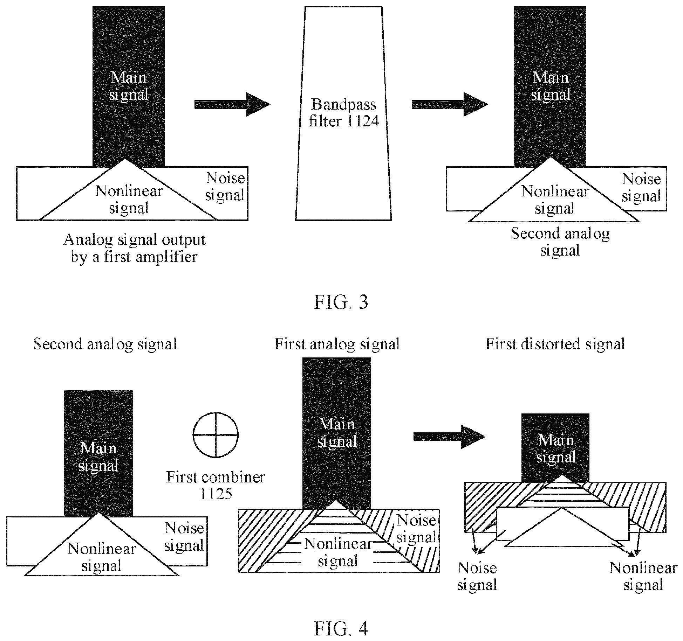

Because the first digital-to-analog converter 1122 and the first amplifier 1123 are nonlinear, after the first digital-to-analog converter 1122 performs digital-to-analog conversion on the first digital signal and the first amplifier 1123 amplifies the first digital signal, an output signal of the first amplifier 1123 includes a distorted signal (including a nonlinear component and a background noise) generated by the first digital-to-analog converter 1122 and the first amplifier 1123. A frequency band of the distorted signal generated by the first digital-to-analog converter 1122 and the first amplifier 1123 may be greater than the operating frequency band of the output signal. A part (namely, an out-of-band distorted signal) of the distorted signal that is generated by the first digital-to-analog converter 1122 and the first amplifier 1123 and that is outside the operating frequency band causes co-channel interference with a distorted signal in the first analog signal, and the co-channel interference affects extraction and cancellation of the distorted signal in the first analog signal. Therefore, as shown in FIG. 3, the bandpass filter 1124 may filter out the out-of-band distorted signal, so that an amplitude of a distorted signal outside the operating frequency band in the second analog signal output by the bandpass filter 1124 is far lower than an amplitude of a distorted signal outside the operating frequency band in the first analog signal. That is, the bandpass filter 1124 can effectively filter out the distorted signal outside the operating frequency band. In FIG. 3, a black rectangle represents a main signal, a triangle represents a nonlinear signal, and a white rectangle represents a noise signal.

It can be learned from the foregoing analysis that, in the solution provided in this embodiment of this application, it can be ensured that the amplitude of the residual distorted signal outside the passband of the bandpass filter 1124 is far lower than the amplitude of the distorted signal in the first analog signal. Therefore, after the second analog signal and the second analog signal are combined by the first combiner 1125, not only the main signal in the first analog signal can be effectively cancelled, but also it can be ensured that generation of the distorted signal in the first analog signal is not affected. In other words, energy of the main signal in a first distorted signal input to an analog-to-digital converter 1132 may be small, a noise signal in the first distorted signal can keep consistent with a noise signal in the first analog signal as much as possible, and a nonlinear signal in the first distorted signal can keep consistent with a nonlinear signal in the first analog signal as much as possible.

Still refer to FIG. 2. The first combiner 1125 is further connected to an output end of the signal amplification sub-circuit 111, and the first combiner 1125 is configured to couple the second analog signal and the first analog signal to obtain the first distorted signal.

In a possible example, the first combiner 1125 may be an analog adder, and the first amplitude and phase modulator 1121 can adjust the amplitude of the first digital signal, and reverse the phase of the first digital signal. Correspondingly, a phase of the second analog signal input to the first combiner 1125 is opposite to a phase of the first analog signal input to the first combiner 1125, and an amplitude of the second analog signal and an amplitude of the first analog signal are approximately equal. After the first combiner 1125 adds the two analog signals, the main signal in the first analog signal may be cancelled, to extract the first distorted signal in the first analog signal.

In another possible example, the first combiner 1125 may be an analog subtractor, and the first amplitude and phase modulator 1121 can adjust the amplitude of the first digital signal without reversing the phase of the first digital signal. Correspondingly, a phase of the second analog signal input to the first combiner 1125 is the same as a phase of the first analog signal input to the first combiner 1125, and an amplitude of the second analog signal and an amplitude of the first analog signal are approximately equal. After the first combiner 1125 subtracts the two analog signals, the main signal in the first analog signal may be cancelled, to extract the first distorted signal in the first analog signal.

Refer to FIG. 4. If the amplitude of the second analog signal input to the first combiner 1125 is not completely equal to the amplitude of the first analog signal input to the first combiner 1125, the first distorted signal output by the first combiner 1125 still has a residual part of the main signal. In addition, as shown in FIG. 4, the nonlinear signal in the first analog signal is superimposed with the nonlinear signal in the second analog signal, and the noise signal in the first analog signal is superimposed with the noise signal in the second analog signal. To be specific, the first distorted signal includes the residual main signal, a superimposed nonlinear signal, and a superimposed noise signal.

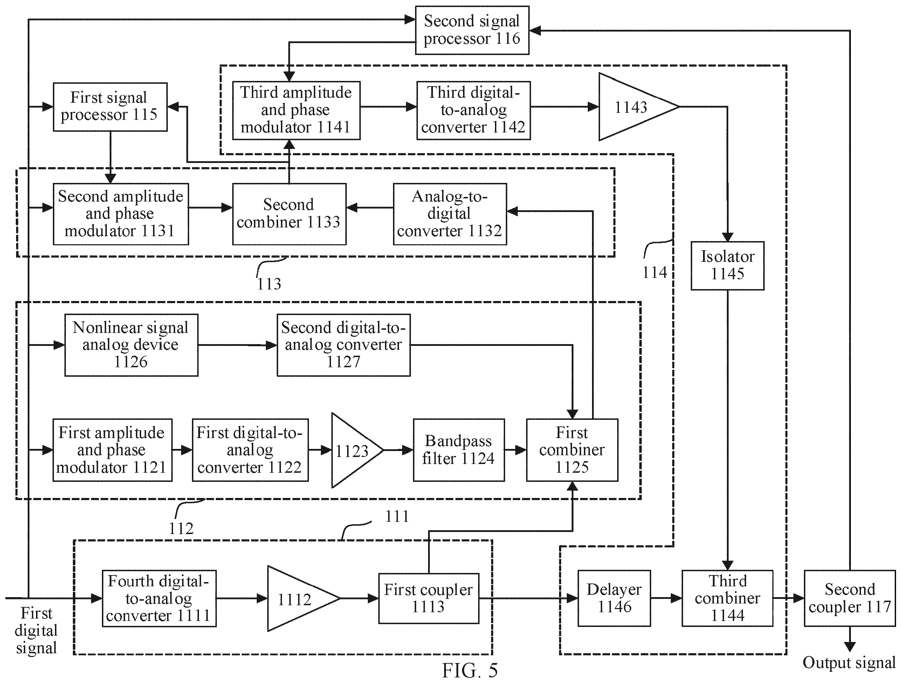

FIG. 5 is a schematic diagram of a structure of another signal amplification circuit according to an embodiment of this application. Refer to FIG. 5. A first signal extraction sub-circuit 112 may further include a nonlinear signal analog device 1126 and a second digital-to-analog converter 1127.

The nonlinear signal analog device 1126 is configured to generate a nonlinear signal based on a first digital signal. The nonlinear signal may be a remote lower-order nonlinear signal, or may be referred to as an intermodulation distortion signal.

The nonlinear signal analog device 1126 may simulate, in a digital domain based on the first digital signal, a remote lower-order nonlinear signal existing in a main signal in a first analog signal. The nonlinear signal analog device 1126 may be a device such as a micro control unit (microcontroller unit, MCU) or a field-programmable logic gate array (field-programmable gate array, FPGA). In addition, the nonlinear signal analog device 1126 may prestore a model used for simulating a nonlinear signal, and the nonlinear signal analog device 1126 can input the first digital signal to the model to obtain the nonlinear signal output by the model. The model may be a relationship function between the digital signal and the remote lower-order nonlinear signal.

It may be understood that, if the first digital signal is a dual-band signal, and frequencies of the dual-band signal are separately F1 and F2, intermodulation distortion occurs after the dual-band signal passes through a power amplifier. That is, the first analog signal further includes an intermodulation distortion signal. Frequencies of the intermodulation distortion signal include 2F1-F2 and 2F2-F1.

The second digital-to-analog converter 1127 is separately connected to the nonlinear signal analog device 1126 and a first combiner 1125, and the second digital-to-analog converter 1127 is configured to perform digital-to-analog conversion on the nonlinear signal to convert the analog nonlinear signal into an analog signal.

Correspondingly, refer to FIG. 5. The first combiner 1125 can couple a second analog signal, the first analog signal, and a nonlinear signal obtained through the digital-to-analog conversion to obtain a first distorted signal.

In this embodiment of this application, the intermodulation distortion signal may be simulated by the nonlinear signal analog device 1126, and both an intermodulation distortion signal obtained through the digital-to-analog conversion and the second analog signal are coupled to the first analog signal. Therefore, not only the main signal in the first analog signal can be effectively cancelled, but also the intermodulation distortion signal in the first analog signal can be effectively cancelled.

Refer to FIG. 2 and FIG. 5. Optionally, a second signal extraction sub-circuit 113 may include a second amplitude and phase modulator 1131, the analog-to-digital converter 1132, and a second combiner 1133.

The second amplitude and phase modulator 1131 is configured to perform amplitude modulation and/or phase modulation on the first digital signal.

The second amplitude and phase modulator 1131 may increase an amplitude of the first digital signal, and/or reverse a phase of the first digital signal. To be specific, the second amplitude and phase modulator 1131 may only increase the amplitude of the first digital signal, or only reverse the phase of the first digital signal, or may not only increase the amplitude of the first digital signal, but also reverse the phase of the first digital signal.

The analog-to-digital converter 1132 is connected to an output end of the first signal extraction sub-circuit 112, and the analog-to-digital converter 1132 is configured to perform analog-to-digital conversion on the first distorted signal output by the first combiner 1125 to convert the first distorted signal into a digital signal.

Based on the foregoing analysis, it can be learned that the first combiner 1125 can couple the second analog signal, the first analog signal, and the intermodulation distortion signal obtained through the digital-to-analog conversion. Therefore, a power change range of the first distorted signal output by the first combiner 1125 is small, and a requirement on a dynamic range of collecting the first distorted signal by the analog-to-digital converter 1132 can be reduced. In other words, a requirement on performance of the analog-to-digital converter 1132 can be reduced, so that an increase in costs of the analog-to-digital converter 1132 is avoided.

The second combiner 1133 is separately connected to the second amplitude and phase modulator 1131 and the analog-to-digital converter 1132. The second combiner 1133 is configured to couple a first distorted signal obtained through the analog-to-digital conversion and an amplitude-modulated and/or phase-modulated first digital signal to obtain a second distorted signal.

It may be understood that, the residual of the main signal may be in the first distorted signal, and the first distorted signal obtained through the analog-to-digital conversion is coupled to the amplitude-modulated and/or phase-modulated first digital signal, so that the residual main signal in the first distorted signal can be effectively cancelled. In addition, because the analog-to-digital converter 1132 may convert the first distorted signal output by the first signal extraction sub-circuit 112 into the digital signal, the second combiner 1133 can extract the distorted signal in the digital domain, so that the main signal is better cancelled.

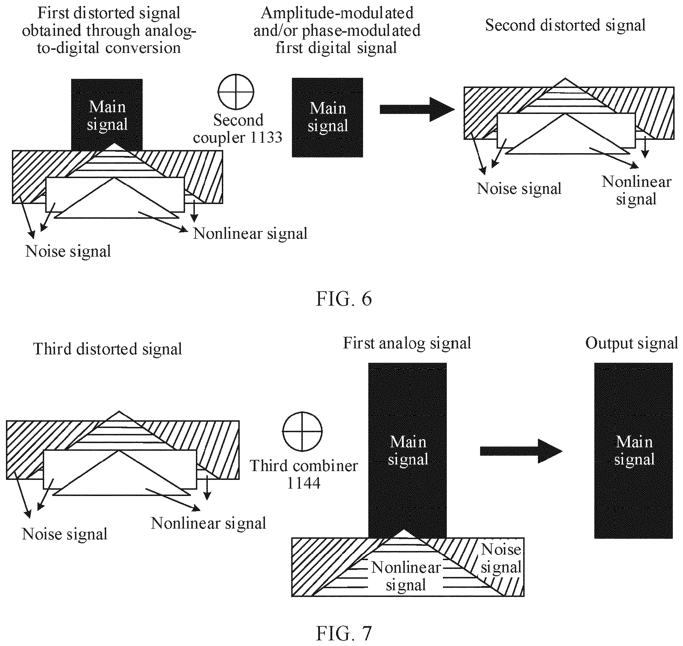

In a possible example, the second combiner 1133 may be a digital adder, and the second amplitude and phase modulator 1131 can adjust the amplitude of the first digital signal, and reverse the phase of the first digital signal. Correspondingly, a phase of the amplitude-modulated and phase-modulated first digital signal input to the second combiner 1133 is opposite to a phase of the residual main signal in the first distorted signal input to the second combiner 1133, and an amplitude of the first digital signal and an amplitude of the residual main signal are approximately equal. After the second combiner 1133 adds the two digital signals, the residual main signal in the first distorted signal may be cancelled, to extract the nonlinear signal and the noise signal in the first distorted signal, and output the nonlinear signal and the noise signal as the second distorted signal. As shown in FIG. 6, the second combiner 1133 is an adder, and the second combiner 1133 may add the two analog signals, cancel the main signal, and output a signal as the nonlinear signal and the noise signal in the first distorted signal.

In another possible example, the second combiner 1133 may be a digital subtractor, and the second amplitude and phase modulator 1131 can adjust the amplitude of the first digital signal without reversing the phase of the first digital signal. Correspondingly, a phase of the amplitude-modulated first digital signal input to the second combiner 1133 is the same as a phase of the residual main signal in the first distorted signal input to the second combiner 1133, and an amplitude of the first digital signal and an amplitude of the residual main signal are approximately equal. After the second combiner 1133 subtracts the two digital signals, the main signal in the first distorted signal may be cancelled, to extract the distorted signal in the first distorted signal, and output the distorted signal as the second distorted signal.

For example, it is assumed that the second combiner 1133 is the adder. As shown in FIG. 6, the second combiner 1133 may add the first distorted signal obtained through the analog-to-digital conversion and the amplitude-modulated and/or phase-modulated first digital signal. Therefore, the main signal in the first distorted signal may be cancelled, and the nonlinear signal and the noise signal in the first distorted signal are extracted. That is, the second distorted signal is extracted from the first distorted signal. Refer to FIG. 6. In an ideal situation, a main signal in the second distorted signal output by the second combiner 1133 can be completely cancelled; or if a main signal is not completely cancelled, a residual part of the main signal remains in the second distorted signal.

Refer to FIG. 2 and FIG. 5. Optionally, the signal amplification circuit provided in this embodiment of this application may further include a first signal processor 115 separately connected to the second combiner 1133 and the second amplitude and phase modulator 1131.

The first signal processor 115 is configured to adjust an amplitude and phase modulation parameter of the second amplitude and phase modulator 1131 based on an error between the second distorted signal and the first digital signal. The first signal processor 115 may be an MCU or a digital signal processor (digital signal processor, DSP).

It may be understood that, an amplitude of the amplitude-modulated and/or phase-modulated first digital signal output by the second amplitude and phase modulator 1131 may be different from an amplitude of the main signal in the first distorted signal obtained through the analog-to-digital conversion, and it is difficult to ensure that a phase of the first digital signal output by the second amplitude and phase modulator 1131 is completely the same as or opposite to a phase of the main signal in the first distorted signal obtained through the analog-to-digital conversion. Correspondingly, the residual part of the main signal remains in the second distorted signal output by the second combiner 1133.

The first signal processor 115 may adjust the amplitude and phase modulation parameter of the second amplitude and phase modulator 1131 based on the error between the second distorted signal and the first digital signal, to adjust an adjustment degree of the phase and/or the amplitude of the first digital signal by the second amplitude and phase modulator 1131. In this way, it can be ensured that when the amplitude-modulated and/or phase-modulated first digital signal output by the second amplitude and phase modulator 1131 is coupled to the first distorted signal obtained through the analog-to-digital conversion, the residual main signal in the first distorted signal can be effectively cancelled.

Optionally, the first signal processor 115 may also be connected to the first amplitude and phase modulator 1121, and adjust an amplitude and phase modulation parameter of the first amplitude and phase modulator 1121 based on the error between the second distorted signal and the first digital signal, to adjust the adjustment degree of the phase and/or the amplitude of the first digital signal by the first amplitude and phase modulator 1121. In this way, it can also be ensured that the residual main signal in the first distorted signal can be effectively cancelled.

Refer to FIG. 5. Optionally, the first signal processor 115 may further be connected to the nonlinear signal analog device 1126, and adjust, based on the error between the second distorted signal and the first digital signal, a parameter of the model stored in the nonlinear signal analog device 1126. The parameter of the model is adjusted, so that the nonlinear signal output by the nonlinear analog device 1126 approximates to the remote lower-order nonlinear signal of the main signal in the first analog signal. This ensures that the remote lower-order nonlinear signal of the main signal in the first analog signal can be better cancelled.

It may be understood that the first signal processor 115 may cyclically adjust the amplitude and phase modulation parameter of the second amplitude and phase modulator 1131 based on the obtained error between the second distorted signal and the first digital signal, until the error is less than an error threshold.

Optionally, as shown in FIG. 2 and FIG. 5, a distorted signal cancellation sub-circuit 114 may include a third amplitude and phase modulator 1141, a third digital-to-analog converter 1142, a second amplifier 1143, a third combiner 1144, and a delayer 1146 that are sequentially connected.

The third amplitude and phase modulator 1141 is further connected to an output end of the second signal extraction sub-circuit 113, and the third amplitude and phase modulator 1141 is configured to perform amplitude modulation and/or phase modulation on the second distorted signal.

The third amplitude and phase modulator 1141 may increase an amplitude of the second distorted signal, and/or reverse a phase of the second distorted signal. To be specific, the third amplitude and phase modulator 1141 may only increase the amplitude of the second distorted signal, or only reverse the phase of the second distorted signal, or may not only increase the amplitude of the second distorted signal, but also reverse the phase of the second distorted signal.

The third digital-to-analog converter 1142 is configured to perform digital-to-analog conversion on an amplitude-modulated and/or phase-modulated second distorted signal output by the third amplitude and phase modulator 1141 to obtain a third distorted signal.

The second amplifier 1143 is configured to perform power amplification on the third distorted signal, and transmit a power-amplified third distorted signal to the third combiner 1144.

Because signal power of the amplitude-modulated and/or phase-modulated second distorted signal output by the third amplitude and phase modulator 1141 is low, power amplification needs to be performed on the amplitude-modulated and/or phase-modulated second distorted signal, namely, the third distorted signal, by the second amplifier 1143. Therefore, power of the third distorted signal loaded to the third combiner 1144 may be approximately equal to power of the first analog signal loaded by the signal amplification sub-circuit 111 to the third combiner 1144. This ensures that the distorted signal in the first analog signal can be effectively cancelled.

The delayer 1146 is further connected to the signal amplification sub-circuit 111 by using a signal cable. The delayer 1146 is configured to delay the first analog signal and then transmit the first analog signal to the third combiner 1144.

The third combiner 1144 is configured to couple the power-amplified third distorted signal and the first analog signal to obtain the output signal.

Optionally, the delayer 1146 may be a device having a delay function, such as a delay line or a delay filter. The delayer 1146 can ensure that the first analog signal output by the signal amplification sub-circuit 111 and the third distorted signal output by the second amplifier 1143 simultaneously arrive at the third combiner 1144, to ensure that the third combiner 1144 can effectively couple the first analog signal and the third distorted signal.

It is assumed that a delay of transmitting a first analog signal output by a power amplifier 1112 in the signal amplification sub-circuit 111 to the third combiner 1144 through a first coupler 1113 and the delayer 1146 is t1, and a delay of transmitting a first analog signal output by the first coupler 1113 to the third distorted signal output by the second amplifier 1143 is t2. In this case, the delays t1 and t2 satisfy t1=t2+t3, where t3 is a delay of the first coupler 1113. To be specific, a delay between inputting the first analog signal to the first coupler 1113 and outputting the first analog signal by the first coupler 1113 to the first combiner 1125 of the first signal extraction sub-circuit 112.

In a possible example, the third combiner 1144 may be an analog adder, and the third amplitude and phase modulator 1141 can adjust the amplitude of the second distorted signal, and reverse the phase of the second distorted signal. Correspondingly, a phase of the third distorted signal input to the third combiner 1144 is opposite to a phase of the distorted signal in the first analog signal input to the third combiner 1144, and an amplitude of the third distorted signal and an amplitude of the distorted signal are approximately equal. After the third combiner 1144 adds the two analog signals, the distorted signal in the first analog signal may be cancelled, to extract the main signal in the first analog signal.

In another possible example, the third combiner 1144 may be an analog subtractor, and the third amplitude and phase modulator 1141 can adjust the amplitude of the second distorted signal without reversing the phase of the second distorted signal. Correspondingly, a phase of the third distorted signal input to the third combiner 1144 is the same as a phase of the distorted signal in the first analog signal input to the third combiner 1144, and an amplitude of the third distorted signal and an amplitude of the distorted signal are approximately equal. After the third combiner 1144 subtracts the two analog signals, the distorted signal in the first analog signal may be cancelled, to extract the main signal in the first analog signal.

As shown in FIG. 7, it is assumed that the third combiner 1144 is an adder. The third combiner 1144 may add the two analog signals to cancel the distorted signal (to be specific, the nonlinear signal and the noise signal) in the first analog signal to obtain the output signal. Refer to FIG. 7. In an ideal situation, a distorted signal in the output signal output by the third combiner 1144 can be completely cancelled; or if a distorted signal is not completely cancelled, a residual part of the distorted signal remains in the output signal.

Refer to FIG. 2 and FIG. 5. Optionally, the distorted signal cancellation sub-circuit 114 may further include an isolator 1145 separately connected to the second amplifier 1143 and the third combiner 1144.

The isolator 1145 is configured to isolate a signal transmitted from the third combiner 1144 to the second amplifier 1143. In this way, a signal that is reversely output by the third combiner 1144 to the second amplifier 1143 can be prevented from affecting working performance of the second amplifier 1143, and the second amplifier 1143 is prevented from generating an extra distorted signal.

Refer to FIG. 2 and FIG. 5. Optionally, the signal amplification circuit provided in this embodiment of this application may further include a second signal processor 116 separately connected to the third combiner 1144 and the third amplitude and phase modulator 1141.

The second signal processor 116 is configured to adjust an amplitude and phase modulation parameter of the third amplitude and phase modulator 1141 based on an error between the output signal and the first digital signal. The second signal processor 116 may be an MCU or a DSP.

It may be understood that, the amplitude of the third distorted signal loaded to the third combiner 1144 may be different from the amplitude of the distorted signal that is in the first analog signal and that is loaded to the third combiner 1144, and it is difficult to ensure that the phase of the third distorted signal is completely the same as or opposite to the phase of the distorted signal that is in the first analog signal and that is loaded to the third combiner 1144. Therefore, the second signal processor 116 may adjust the amplitude and phase modulation parameter of the third amplitude and phase modulator 1141, to adjust an adjustment degree of the amplitude and/or the phase of the second distorted signal by the third amplitude and phase modulator 1141. Therefore, the amplitude of the third distorted signal obtained based on the second distorted signal may be as equal as possible to the amplitude of the distorted signal in the first analog signal transmitted by the signal amplification sub-circuit 111 to the third combiner 1144, and the phase of the third distorted signal may be as same as or opposite to the phase of the distorted signal in the first analog signal transmitted by the signal amplification sub-circuit 111 to the third combiner 1144 as possible. Correspondingly, it can be ensured that the distorted signal in the output signal output by the third combiner 1144 can be effectively cancelled.

It may be understood that a process in which the third amplitude and phase modulator 1141, the third digital-to-analog converter 1142, and the second amplifier 1143 process the second distorted signal may also be referred to as a distorted signal fitting process. Alternatively, it may be understood as that the third amplitude and phase modulator 1141, the third digital-to-analog converter 1142, and the second amplifier 1143 sequentially process the second distorted signal to obtain a third distorted signal that can approximate the distorted signal in the first analog signal.

It may be further understood that the second signal processor 116 may cyclically adjust the amplitude and phase modulation parameter of the third amplitude and phase modulator 1141 based on the obtained error between the output signal and the first digital signal, until the error is less than an error threshold. Correspondingly, the third amplitude and phase modulator 1141 can consecutively adjust the amplitude and/or the phase of the second distorted signal based on an updated amplitude and phase modulation parameter, so that the amplitude of the third distorted signal approximates the amplitude of the distorted signal in the first analog signal, and the phase of the third distorted signal approximates the phase of the distorted signal in the first analog signal. That is, fitting precision of the third distorted signal can be continuously improved.

Optionally, as shown in FIG. 2 and FIG. 5, the signal amplification sub-circuit 111 may include a fourth digital-to-analog converter 1111, the power amplifier 1112, and the first coupler 1113 that are sequentially connected. The digital-to-analog converter 1111 is configured to convert the first digital signal into an analog signal. The power amplifier 1112 is configured to perform power amplification on the analog signal to obtain the first analog signal. The first coupler 1113 is further separately connected to the first signal extraction sub-circuit 112 and the distorted signal cancellation sub-circuit 114, and is configured to separately transmit the first analog signal to the first signal extraction sub-circuit 112 and the distorted signal cancellation sub-circuit 114.

For example, the first coupler 1113 may transmit a part of the first analog signal to the first combiner 1125 in the first signal extraction sub-circuit 112, and may transmit the other part of the first analog signal to the delayer 1146 in the distorted signal cancellation sub-circuit 114.

It may be understood that the first coupler 1113 may divide the first analog signal into two channels based on the power of the first analog signal and output the two channels. Power of each channel of the first analog signal output by the first coupler 1113 is in a linear relationship with power of the first analog signal input to the first coupler 1113. In addition, power of the channel of the first analog signal output by the first coupler 1113 to the first signal extraction sub-circuit 112 is far lower than power of the channel of the first analog signal output by the first coupler 1113 to the distorted signal cancellation sub-circuit 114. In this way, impact on normal transmission of the output signal sent by the distorted signal cancellation sub-circuit 114 can be avoided.

For example, the power of the channel of the first analog signal output by the first coupler 1113 to the first signal extraction sub-circuit 112 may be 1% of the power of the first analog signal input to the first coupler 1113. The power of the channel of the first analog signal output by the first coupler 1113 to the distorted signal cancellation sub-circuit 114 may be 99% of the power of the first analog signal input to the first coupler 1113.

Still refer to FIG. 2 and FIG. 5. Optionally, the signal amplification circuit provided in this embodiment of this application may further include a second coupler 117. The second coupler 117 may divide the output signal into two channels based on power of the output signal and output the two channels. Power of each channel of the output signal output by the second coupler 117 is in a linear relationship with power of the output signal input to the second coupler 117. In addition, power of the channel of the output signal output by the second coupler 117 to the second signal processor 116 is far lower than power of the output signal output by the second coupler 117 to a next-level circuit (for example, a filter) of the signal amplification circuit 110. In this way, impact on normal transmission of an output signal output by the signal amplification circuit 110 to the next-level circuit can be avoided.

For example, the power of the channel of the output signal output by the second coupler 117 to the second signal processor 116 may be 1% of the power of the output signal input to the second coupler 117. The power of the output signal output by the second coupler 117 to the next-level circuit of the signal amplification circuit 110 may be 99% of the power of the first analog signal input to the second coupler 117.

In conclusion, this embodiment of this application provides a signal amplification circuit. After performing digital-to-analog conversion and power amplification on the first digital signal to obtain the first analog signal, the signal amplification circuit may extract, in an analog domain and the digital domain, the distorted signal in the first analog signal, and couple the extracted distorted signal and the first analog signal to obtain the output signal. Because the signal amplification circuit can successively extract the distorted signal in the analog domain and the digital domain, it can be ensured that the residual of the main signal in the extracted distorted signal is small. Therefore, it can be ensured that after the distorted signal is coupled to the first analog signal, the distorted signal in the first analog signal can be effectively cancelled, thereby effectively improving linearity of the output signal that is finally output.

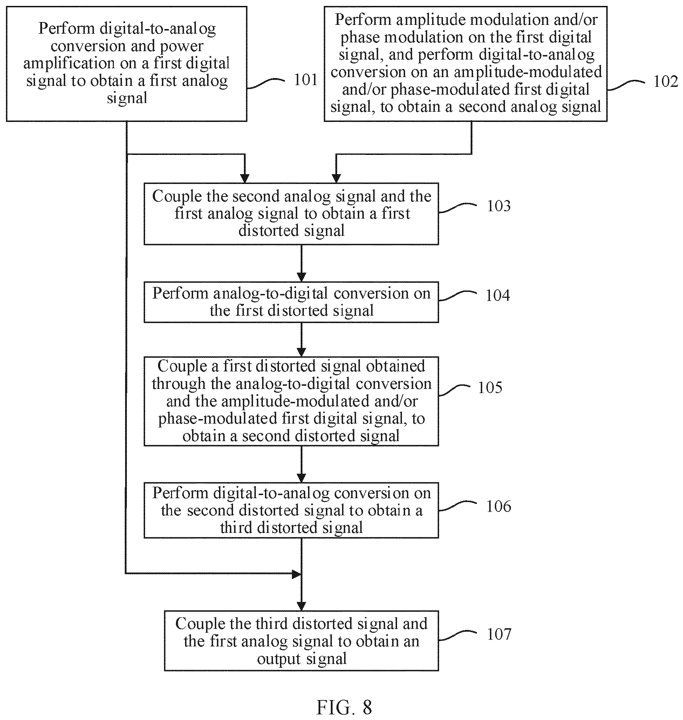

FIG. 8 is a flowchart of a signal amplification method according to an embodiment of this application. The method may be applied to the signal amplification circuit provided in the foregoing embodiment, for example, may be applied to the signal amplification circuit shown in FIG. 1, FIG. 2, or FIG. 5. Refer to FIG. 8. The method includes the following steps.

Step 101: Perform digital-to-analog conversion and power amplification on a first digital signal to obtain a first analog signal.

Refer to FIG. 1, FIG. 2, and FIG. 5. In this embodiment of this application, the signal amplification circuit includes a signal amplification sub-circuit, and the signal amplification sub-circuit can perform digital-to-analog conversion and power amplification on the input first digital signal to obtain the first analog signal.

For example, a fourth digital-to-analog converter in the signal amplification sub-circuit may convert the first digital signal into the analog signal, and transmit a first digital signal obtained through the digital-to-analog conversion to a power amplifier. The power amplifier may further perform power amplification on the first digital signal obtained through the digital-to-analog conversion to obtain the first analog signal. Because nonlinear distortion is generated when the power amplifier performs power amplification on the first digital signal obtained through the digital-to-analog conversion, the first analog signal not only includes a main signal, but also includes a nonlinear signal and a noise signal, namely, a distorted signal.

Step 102: Perform amplitude modulation and/or phase modulation on the first digital signal, and perform digital-to-analog conversion on an amplitude-modulated and/or phase-modulated first digital signal to obtain a second analog signal.

Refer to FIG. 1, FIG. 2, and FIG. 5. The signal amplification circuit further includes a first signal extraction sub-circuit. The first signal extraction sub-circuit can perform amplitude modulation and/or phase modulation on the input first digital signal, and perform digital-to-analog conversion on the amplitude-modulated and/or phase-modulated first digital signal to obtain the second analog signal.

For example, a first amplitude and phase modulator in the first signal extraction sub-circuit may perform amplitude modulation and/or phase modulation on the first digital signal, and a first digital-to-analog converter may convert the amplitude-modulated and/or phase-modulated first digital signal into the analog signal to obtain the second analog signal.

Step 103: Couple the second analog signal and the first analog signal to obtain a first distorted signal.

Still refer to FIG. 1, FIG. 2, and FIG. 5. The first signal extraction sub-circuit of the signal amplification circuit may further couple the second analog signal and the first analog signal to obtain the first distorted signal.

For example, a first combiner in the first signal extraction sub-circuit may couple the second analog signal and the first analog signal, to cancel the main signal in the first analog signal, and obtain the first distorted signal. That is, the first combiner can extract, in an analog domain, the distorted signal in the first analog signal.

Step 104: Perform analog-to-digital conversion on the first distorted signal.

Refer to FIG. 1, FIG. 2, and FIG. 5. The signal amplification circuit includes a second signal extraction sub-circuit, and the second signal extraction sub-circuit can perform analog-to-digital conversion on the first distorted signal to convert the first distorted signal into a digital signal.

For example, an analog-to-digital converter in the second signal extraction sub-circuit may convert the first distorted signal into the digital signal.

Step 105: Couple a first distorted signal obtained through the analog-to-digital conversion and an amplitude-modulated and/or phase-modulated first digital signal to obtain a second distorted signal.

Still refer to FIG. 1, FIG. 2, and FIG. 5. The second signal extraction sub-circuit in the signal amplification circuit may further couple the first distorted signal obtained through the analog-to-digital conversion and the first digital signal, to further cancel the residual main signal in the first distorted signal and obtain the second distorted signal.

For example, a second combiner in the second signal extraction sub-circuit may couple a first distorted signal obtained through the analog-to-digital conversion and an amplitude-modulated and/or phase-modulated first digital signal to obtain the second distorted signal. That is, the second combiner may extract, in a digital domain, a distorted signal in the first distorted signal.

Step 106: Perform digital-to-analog conversion on the second distorted signal to obtain a third distorted signal.

Still refer to FIG. 1, FIG. 2, and FIG. 5. The signal amplification circuit includes a distorted signal cancellation sub-circuit, and the distorted signal cancellation sub-circuit may perform digital-to-analog conversion on the second distorted signal, and convert the second distorted signal into an analog signal to obtain the third distorted signal.

For example, a third digital-to-analog converter in the distorted signal cancellation sub-circuit may convert the second distorted signal into the analog signal.

Step 107: Couple the third distorted signal and the first analog signal to obtain an output signal.

Refer to FIG. 1, FIG. 2, and FIG. 5. The distorted signal cancellation sub-circuit may couple the third distorted signal and the first analog signal, and cancel the distorted signal in the first analog signal to obtain the output signal.

For example, a third combiner in the distorted signal cancellation sub-circuit may couple the third distorted signal and the first analog signal, to cancel the distorted signal in the first analog signal and obtain the output signal.

In conclusion, this embodiment of this application provides a signal amplification method. In the method, after digital-to-analog conversion and power amplification are performed on the first digital signal to obtain the first analog signal, the distorted signal in the first analog signal can be extracted in the analog domain and the digital domain separately, and the extracted distorted signal is coupled to the first analog signal to obtain the output signal. Because the signal amplification method can successively extract the distorted signal in the analog domain and the digital domain, it can be ensured that a residual of the main signal in the extracted distorted signal is small. Therefore, it can be ensured that after the distorted signal is coupled to the first analog signal, the distorted signal in the first analog signal can be effectively cancelled, thereby effectively improving linearity of the output signal that is finally output.

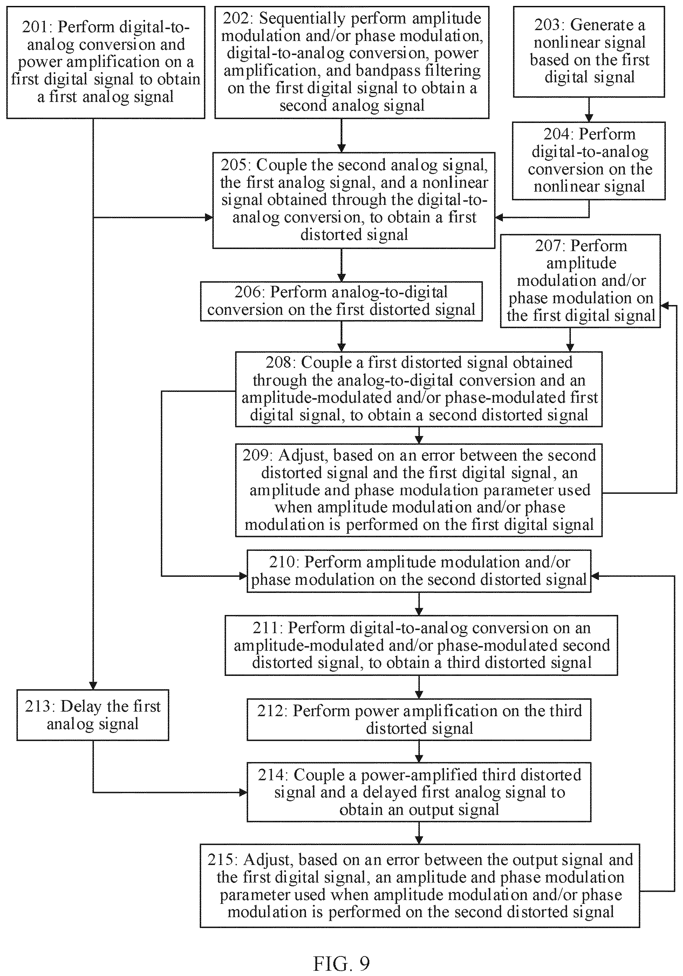

FIG. 9 is a flowchart of another signal amplification method according to an embodiment of this application. The method may be applied to the signal amplification circuit provided in the foregoing embodiment, for example, may be applied to the signal amplification circuit shown in FIG. 1, FIG. 2, or FIG. 5. Refer to FIG. 9. The method includes the following steps.

Step 201: Perform digital-to-analog conversion and power amplification on a first digital signal to obtain a first analog signal.

Refer to FIG. 1, FIG. 2, and FIG. 5. In this embodiment of this application, the signal amplification circuit includes a signal amplification sub-circuit. A fourth digital-to-analog converter in the signal amplification sub-circuit may convert the input first digital signal into an analog signal, and a power amplifier in the signal amplification sub-circuit may perform power amplification on a first digital signal obtained through the digital-to-analog conversion to obtain the first analog signal.

Step 202: Sequentially perform amplitude modulation and/or phase modulation, digital-to-analog conversion, power amplification, and bandpass filtering on the first digital signal to obtain a second analog signal.

Refer to FIG. 1, FIG. 2, and FIG. 5. The signal amplification circuit includes a first signal extraction sub-circuit, and the signal extraction sub-circuit may include a first amplitude and phase modulator, a first digital-to-analog converter, a first amplifier, and a bandpass filter that are sequentially connected. The first amplitude and phase modulator can perform amplitude modulation and/or phase modulation on the input first digital signal.

The first digital-to-analog converter may perform digital-to-analog conversion on an amplitude-modulated and/or phase-modulated first digital signal output by the first amplitude and phase modulator to convert the amplitude-modulated and/or phase-modulated first digital signal into an analog signal.

The first amplifier can perform power amplification on the signal output by the first digital-to-analog converter. Therefore, power of the second analog signal loaded to a first combiner may be approximately equal to power of the first analog signal loaded by the signal amplification sub-circuit to the first combiner. This ensures that a main signal in the first analog signal can be effectively cancelled.

The bandpass filter can perform bandpass filtering on a signal output by the first amplifier to obtain the second analog signal. A filtering passband of the bandpass filtering is greater than or equal to an operating frequency band of an output signal. Because the first digital-to-analog converter and the first amplifier are nonlinear, after the first digital-to-analog converter performs digital-to-analog conversion on the first digital signal and the first amplifier amplifies the first digital signal, the output signal of the first amplifier includes a distorted signal generated by the first digital-to-analog converter and the first amplifier. The bandpass filter can filter out a distorted signal outside a passband, so that a distorted signal outside the operating frequency band of the output signal in the second analog signal output by the bandpass filter is effectively filtered out.

Step 203: Generate a nonlinear signal based on the first digital signal.

The nonlinear signal analog device in the first signal extraction sub-circuit may analogously generate, based on the first digital signal, a remote lower-order nonlinear signal existing in the main signal. The nonlinear signal analog device may prestore a model used for simulating a nonlinear signal, and the nonlinear signal analog device can input the first digital signal to the model to obtain the nonlinear signal output by the model.

Step 204: Perform digital-to-analog conversion on the nonlinear signal.

A second digital-to-analog converter in the first signal extraction sub-circuit can perform digital-to-analog conversion on the nonlinear signal output by the nonlinear analog device to convert the nonlinear signal into an analog signal.

Step 205: Couple the second analog signal, the first analog signal, and a nonlinear signal obtained through the digital-to-analog conversion to obtain a first distorted signal.

The first signal extraction sub-circuit further includes the first combiner. The first combiner can couple the second analog signal, the first analog signal, and the nonlinear signal (namely, an intermodulation distortion signal) obtained through the digital-to-analog conversion, to cancel the main signal and the intermodulation distortion signal in the first analog signal and obtain the first distorted signal.

Step 206: Perform analog-to-digital conversion on the first distorted signal.

Refer to FIG. 1, FIG. 2, and FIG. 5. The signal amplification circuit further includes a second signal extraction sub-circuit. An analog-to-digital converter in the second signal extraction sub-circuit can perform analog-to-digital conversion on the first distorted signal to convert the first distorted signal into a digital signal.

Step 207: Perform amplitude modulation and/or phase modulation on the first digital signal.

A second amplitude and phase modulator in the second signal extraction sub-circuit can perform amplitude modulation and/or phase modulation on the input first digital signal.

Step 208: Couple a first distorted signal obtained through the analog-to-digital conversion and an amplitude-modulated and/or phase-modulated first digital signal to obtain a second distorted signal.

A second combiner in the second signal extraction sub-circuit can couple a first distorted signal obtained through the analog-to-digital conversion and an amplitude-modulated and/or phase-modulated first digital signal to obtain the second distorted signal.

It may be understood that, a residual of the main signal may be in the first distorted signal, and the first distorted signal obtained through the analog-to-digital conversion is coupled to the amplitude-modulated and/or phase-modulated first digital signal, so that the residual main signal in the first distorted signal can be effectively cancelled. In addition, because the analog-to-digital converter of the second signal extraction sub-circuit may convert the first distorted signal output by the first signal extraction sub-circuit into the digital signal, the second combiner can extract the distorted signal in a digital domain, so that the main signal is better cancelled.

Step 209: Adjust, based on an error between the second distorted signal and the first digital signal, an amplitude and phase modulation parameter used when amplitude modulation and/or phase modulation is performed on the first digital signal.

The amplitude and phase modulation parameter used when amplitude modulation and/or phase modulation is performed on the first digital signal is an amplitude and phase modulation parameter of a second amplitude and phase modulation device. Refer to FIG. 1, FIG. 2, and FIG. 5. A first signal processor in the signal amplification circuit may adjust the amplitude and phase modulation parameter of the second amplitude and phase modulator based on the error between the second distorted signal and the first digital signal, to adjust an adjustment degree of a phase and/or an amplitude of the first digital signal by the second amplitude and phase modulator. In this way, it can be ensured that when the amplitude-modulated and/or phase-modulated first digital signal output by the second amplitude and phase modulator is coupled to the first distorted signal obtained through the analog-to-digital conversion, the residual main signal in the first distorted signal can be effectively cancelled.

Optionally, the first signal processor may further adjust an amplitude and phase modulation parameter of the first amplitude and phase modulator of the first signal extraction sub-circuit based on the error between the second distorted signal and the first digital signal, to adjust an adjustment degree of the phase and/or the amplitude of the first digital signal by the first amplitude and phase modulator. In this way, it can also be ensured that the residual main signal in the first distorted signal can be effectively cancelled.

Optionally, the first signal processor may further adjust, based on the error between the second distorted signal and the first digital signal, a parameter of the model stored in the nonlinear signal analog device in the first signal extraction sub-circuit. The parameter of the model is adjusted, so that the nonlinear signal output by the nonlinear signal analog device approximates to the remote lower-order nonlinear signal of the main signal in the first analog signal. This ensures that the remote lower-order nonlinear signal of the main signal in the first analog signal can be better cancelled.

Step 210: Perform amplitude modulation and/or phase modulation on the second distorted signal.

Refer to FIG. 1, FIG. 2, and FIG. 5. The signal amplification sub-circuit further includes a distorted signal cancellation sub-circuit. A third amplitude and phase modulator in the distorted signal cancellation sub-circuit can perform amplitude modulation and/or phase modulation on the second distorted signal.

Step 211: Perform digital-to-analog conversion on an amplitude-modulated and/or phase-modulated second distorted signal to obtain a third distorted signal.

A third digital-to-analog converter in the distorted signal cancellation sub-circuit can perform digital-to-analog conversion on the amplitude-modulated and/or phase-modulated second distorted signal to convert the amplitude-modulated and/or phase-modulated second distorted signal into the analog signal.

Step 212: Perform power amplification on the third distorted signal.

A second amplifier in the distorted signal cancellation sub-circuit may perform power amplification on the third distorted signal.

Step 213: Delay the first analog signal.

A delayer in the distorted signal cancellation sub-circuit can delay the first analog signal transmitted by the signal amplification sub-circuit to a third combiner. The delayer can ensure that the first analog signal output by the signal amplification sub-circuit and the third distorted signal output by the second amplifier simultaneously arrive at the third combiner, to ensure that the third combiner can effectively couple the first analog signal and the third distorted signal.

Step 214: Couple a power-amplified third distorted signal and a delayed first analog signal to obtain the output signal.

The third combiner in the distorted signal cancellation sub-circuit can couple the power-amplified third distorted signal and the delayed first analog signal.

Step 215: Adjust, based on an error between the output signal and the first digital signal, an amplitude and phase modulation parameter used when amplitude modulation and/or phase modulation is performed on the second distorted signal.

The amplitude and phase modulation parameter used when amplitude modulation and/or phase modulation is performed on the second distorted signal is an amplitude and phase modulation parameter of the third amplitude and phase modulator. Refer to FIG. 1, FIG. 2, and FIG. 5. A second signal processor in the distorted signal cancellation sub-circuit can adjust, based on the error between the output signal and the first digital signal, the amplitude and phase modulation parameter used when the third amplitude and phase modulator performs amplitude modulation and/or phase modulation on the second distorted signal.

It should be understood that a sequence of the steps in the signal amplification method provided in this embodiment of this application may be properly adjusted, or the steps may be correspondingly added or deleted based on a situation. For example, step 203 and step 204 may be performed before step 201, or may be deleted according to a situation. Alternatively, step 212 may be deleted according to a situation. Alternatively, step 209 and/or step 215 may be deleted according to a situation.

In conclusion, this embodiment of this application provides a signal amplification method. In the method, after digital-to-analog conversion and power amplification are performed on the first digital signal to obtain the first analog signal, the distorted signal in the first analog signal can be extracted in an analog domain and the digital domain separately, and the extracted distorted signal is coupled to the first analog signal to obtain the output signal. Because the signal amplification method can successively extract the distorted signal in the analog domain and the digital domain, it can be ensured that the residual of the main signal in the extracted distorted signal is small. Therefore, it can be ensured that after the distorted signal is coupled to the first analog signal, the distorted signal in the first analog signal can be effectively cancelled, thereby effectively improving linearity of the output signal that is finally output.

It may be clearly understood by a person skilled in the art that, for the purpose of convenient and brief description, for an implementation process of the signal amplification method described above, refer to related descriptions in the foregoing embodiment of the signal amplification circuit, and details are not described herein again.

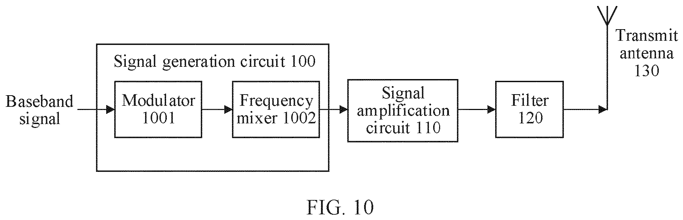

FIG. 10 is a schematic diagram of a structure of a signal transmitter according to an embodiment of this application. As shown in FIG. 10, the signal transmitter includes a signal generation circuit 100 and the signal amplification circuit 110 provided in the foregoing embodiment. The signal generation circuit 100 is configured to transmit a first digital signal to the signal amplification circuit 110.

Optionally, as shown in FIG. 10, the signal generation circuit 100 includes a modulator 1001 and a frequency mixer 1002. The modulator 1001 is configured to modulate a digital baseband signal. The frequency mixer 1002 is configured to: perform up-conversion on a signal output by the modulator to obtain the first digital signal, and send the first digital signal to the signal amplification circuit 110.

Still refer to FIG. 10. The signal transmitter may further include a filter 120 and a transmit antenna 130. The filter 120 is configured to perform bandpass filtering on an output signal output by the signal amplification circuit 110. The transmit antenna 130 is configured to radiate an output signal obtained through the bandpass filtering to surrounding space, to ensure that a signal receiver can receive the output signal.

The "and/or" mentioned in this specification indicates that three relationships may exist. For example, A and/or B may indicate the following three cases: Only A exists, both A and B exist, and only B exists. The character "/" generally indicates an "or" relationship between the associated objects.

The foregoing descriptions are merely example embodiments of this application, but are not intended to limit this application. The scope of protection of this application is defined by the appended claims.

## Claims

1. A signal amplification circuit, wherein the signal amplification circuit comprises a signal amplification sub-circuit, a first signal extraction sub-circuit, a second signal extraction sub-circuit, and a distorted signal cancellation sub-circuit, wherein
the signal amplification sub-circuit is configured to perform digital-to-analog conversion and power amplification on a first digital signal to obtain a first analog signal;
the first signal extraction sub-circuit is configured to: perform amplitude modulation and/or phase modulation on the first digital signal, perform digital-to-analog conversion on an amplitude-modulated and/or phase-modulated first digital signal to obtain a second analog signal, and couple the second analog signal and the first analog signal to obtain a first distorted signal;
the second signal extraction sub-circuit is configured to: perform analog-to-digital conversion on the first distorted signal, perform amplitude modulation and/or phase modulation on the first digital signal, and couple a first distorted signal obtained through the analog-to-digital conversion and an amplitude-modulated and/or phase-modulated first digital signal to obtain a second distorted signal; and
the distorted signal cancellation sub-circuit is configured to: perform digital-to-analog conversion on the second distorted signal to obtain a third distorted signal, and couple the third distorted signal and the first analog signal to obtain an output signal.

2. The signal amplification circuit according to claim **1,** wherein the first signal extraction sub-circuit is configured to sequentially perform digital-to-analog conversion, power amplification, and bandpass filtering on the amplitude-modulated and/or phase-modulated first digital signal to obtain the second analog signal, wherein
a filtering passband of the bandpass filtering is greater than or equal to an operating frequency band of the output signal.

3. The signal amplification circuit according to claim 2, wherein the first signal extraction sub-circuit comprises a first amplitude and phase modulator, a first digital-to-analog converter, a first amplifier, a bandpass filter, and a first combiner that are sequentially connected, wherein
the first amplitude and phase modulator is configured to perform amplitude modulation and/or phase modulation on the first digital signal;
the first digital-to-analog converter is configured to perform digital-to-analog conversion on an amplitude-modulated and/or phase-modulated first digital signal output by the first amplitude and phase modulator;
the first amplifier is configured to perform power amplification on a signal output by the first digital-to-analog converter;
the bandpass filter is configured to perform bandpass filtering on a signal output by the first amplifier to obtain the second analog signal; and
the first combiner is further connected to the signal amplification sub-circuit, and the first combiner is configured to couple the second analog signal and the first analog signal to obtain the first distorted signal.

4. The signal amplification circuit according to claim 3, wherein the first signal extraction sub-circuit further comprises a nonlinear signal analog device and a second digital-to-analog converter, wherein
the nonlinear signal analog device is configured to generate a nonlinear signal based on the first digital signal;
the second digital-to-analog converter is separately connected to the nonlinear signal analog device and the first combiner, and the second digital-to-analog converter is configured to perform digital-to-analog conversion on the nonlinear signal; and
the first combiner is configured to couple the second analog signal, the first analog signal, and a nonlinear signal obtained through the digital-to-analog conversion to obtain the first distorted signal.

5. The signal amplification circuit according to any one of claims 1 to 4, wherein the second signal extraction sub-circuit comprises a second amplitude and phase modulator, an analog-to-digital converter, and a second combiner, wherein
the second amplitude and phase modulator is configured to perform amplitude modulation and/or phase modulation on the first digital signal;
the analog-to-digital converter is connected to the first signal extraction sub-circuit, and the analog-to-digital converter is configured to perform analog-to-digital conversion on the first distorted signal; and
the second combiner is separately connected to the second amplitude and phase modulator and the analog-to-digital converter, and the second combiner is configured to couple a first distorted signal obtained through the analog-to-digital conversion and an amplitude-modulated and/or phase-modulated first digital signal to obtain the second distorted signal.

6. The signal amplification circuit according to claim 5, wherein the signal amplification circuit further comprises a first signal processor separately connected to the second combiner and the second amplitude and phase modulator, wherein
the first signal processor is configured to adjust an amplitude and phase modulation parameter of the second amplitude and phase modulator based on an error between the second distorted signal and the first digital signal.

7. The signal amplification circuit according to any one of claims 1 to 6, wherein the distorted signal cancellation sub-circuit comprises a third amplitude and phase modulator, a third digital-to-analog converter, a second amplifier, a third combiner, and a delayer that are sequentially connected, wherein
the third amplitude and phase modulator is further connected to the second signal extraction sub-circuit, and the third amplitude and phase modulator is configured to perform amplitude modulation and/or phase modulation on the second distorted signal;
the third digital-to-analog converter is configured to perform digital-to-analog conversion on an amplitude-modulated and/or phase-modulated second distorted signal output by the third amplitude and phase modulator to obtain the third distorted signal;
the second amplifier is configured to perform power amplification on the third distorted signal;
the delayer is further connected to the signal amplification sub-circuit, and the delayer is configured to delay the first analog signal and then transmit the first analog signal to the third combiner; and
the third combiner is configured to couple a power-amplified third distorted signal and the first analog signal to obtain the output signal.

8. The signal amplification circuit according to claim 7, wherein the distorted signal cancellation sub-circuit further comprises an isolator separately connected to the second amplifier and the third combiner, wherein
the isolator is configured to isolate a signal transmitted from the third combiner to the second amplifier.

9. The signal amplification circuit according to claim 7 or 8, wherein the signal amplification circuit further comprises a second signal processor separately connected to the third combiner and the third amplitude and phase modulator, wherein
the second signal processor is configured to adjust an amplitude and phase modulation parameter of the third amplitude and phase modulator based on an error between the output signal and the first digital signal.

10. A signal amplification method, wherein the method comprises:
performing digital-to-analog conversion and power amplification on a first digital signal to obtain a first analog signal;
performing amplitude modulation and/or phase modulation on the first digital signal, and performing digital-to-analog conversion on an amplitude-modulated and/or phase-modulated first digital signal to obtain a second analog signal;
coupling the second analog signal and the first analog signal to obtain a first distorted signal;
performing analog-to-digital conversion on the first distorted signal;
coupling a first distorted signal obtained through the analog-to-digital conversion and an amplitude-modulated and/or phase-modulated first digital signal to obtain a second distorted signal;
performing digital-to-analog conversion on the second distorted signal to obtain a third distorted signal; and
coupling the third distorted signal and the first analog signal to obtain an output signal.

11. The method according to claim 10, wherein the performing digital-to-analog conversion on an amplitude-modulated and/or phase-modulated first digital signal to obtain a second analog signal comprises:
sequentially performing digital-to-analog conversion, power amplification, and bandpass filtering on the amplitude-modulated and/or phase-modulated first digital signal to obtain the second analog signal, wherein
a filtering passband of the bandpass filtering is greater than or equal to an operating frequency band of the output signal.

12. The method according to claim 10 or 11, wherein the method further comprises:
generating a nonlinear signal based on the first digital signal; and
performing digital-to-analog conversion on the nonlinear signal, wherein
the coupling the second analog signal and the first analog signal to obtain a first distorted signal comprises:
coupling the second analog signal, the first analog signal, and a nonlinear signal obtained through the digital-to-analog conversion to obtain the first distorted signal.

13. The method according to any one of claims 10 to 12, wherein the method further comprises:
adjusting, based on an error between the second distorted signal and the first digital signal, an amplitude and phase modulation parameter used when amplitude modulation and/or phase modulation is performed on the first digital signal.

14. The method according to any one of claims 10 to 13, wherein the performing digital-to-analog conversion on the second distorted signal to obtain a third distorted signal comprises:
performing amplitude modulation and/or phase modulation on the second distorted signal; and
performing digital-to-analog conversion on an amplitude-modulated and/or phase-modulated second distorted signal to obtain the third distorted signal, wherein
the coupling the third distorted signal and the first analog signal to obtain an output signal comprises:
performing power amplification on the third distorted signal;
delaying the first analog signal; and
coupling a power-amplified third distorted signal and the delayed first analog signal to obtain the output signal.

15. A signal transmitter, wherein the signal transmitter comprises a signal generation circuit and the signal amplification circuit according to any one of claims 1 to 9, wherein
the signal generation circuit is connected to the signal amplification circuit, and the signal generation circuit is configured to transmit a first digital signal to the signal amplification circuit.

## Patentansprüche

1. Signalverstärkungsschaltung, wobei die Signalverstärkungsschaltung eine Signalverstärkungs-Teilschaltung, eine erste Signalextraktions-Teilschaltung, eine zweite Signalextraktions-Teilschaltung und eine Teilschaltung zur Unterdrückung verzerrter Signale umfasst, wobei
die Signalverstärkungs-Teilschaltung dazu konfiguriert ist, eine Digital-Analog-Wandlung und eine Leistungsverstärkung an einem ersten digitalen Signal durchzuführen, um ein erstes analoges Signal zu erlangen;
die erste Signalextraktions-Teilschaltung dazu konfiguriert ist: eine Amplitudenmodulation und/oder eine Phasenmodulation an dem ersten digitalen Signal durchzuführen, eine Digital-Analog-Wandlung an einem amplitudenmodulierten und/oder phasenmodulierten ersten digitalen Signal durchzuführen, um ein zweites analoges Signal zu erlangen, und das zweite analoge Signal und das erste analoge Signal zu koppeln, um ein erstes verzerrtes Signal zu erlangen;
die zweite Signalextraktions-Teilschaltung dazu konfiguriert ist: eine Analog-Digital-Wandlung an dem ersten verzerrten Signal durchzuführen, eine Amplitudenmodulation und/oder eine Phasenmodulation an dem ersten digitalen Signal durchzuführen und ein erstes verzerrtes Signal, das durch die Analog-Digital-Wandlung erlangt wird, und ein amplitudenmoduliertes und/oder phasenmoduliertes erstes digitales Signal zu koppeln, um ein zweites verzerrtes Signal zu erlangen; und
die Teilschaltung zur Unterdrückung verzerrter Signale dazu konfiguriert ist: eine Digital-Analog-Wandlung des zweiten verzerrten Signals durchzuführen, um ein drittes verzerrtes Signal zu erlangen, und das dritte verzerrte Signal und das erste analoge Signal zu koppeln, um ein Ausgabesignal zu erlangen.

2. Signalverstärkungsschaltung nach Anspruch 1, wobei die erste Signalextraktions-Teilschaltung dazu konfiguriert ist, sequenziell eine Digital-Analog-Wandlung, eine Leistungsverstärkung und eine Bandpassfilterung an dem amplitudenmodulierten und/oder phasenmodulierten ersten digitalen Signal durchzuführen, um das zweite analoge Signal zu erlangen, wobei
ein Filterdurchlassbereich der Bandpassfilterung größer oder gleich einem Betriebsfrequenzband des Ausgabesignals ist.

3. Signalverstärkungsschaltung nach Anspruch 2, wobei die erste Signalextraktions-Teilschaltung einen ersten Amplituden- und Phasenmodulator, einen ersten Digital-Analog-Wandler, einen ersten Verstärker, einen Bandpassfilter und einen ersten Kombinierer umfasst, die sequenziell verbunden sind, wobei
der erste Amplituden- und Phasenmodulator dazu konfiguriert ist, eine Amplitudenmodulation und/oder eine Phasenmodulation an dem ersten digitalen Signal durchzuführen;
der erste Digital-Analog-Wandler dazu konfiguriert ist, eine Digital-Analog-Wandlung an einem amplitudenmodulierten und/oder phasenmodulierten ersten digitalen Signal durchzuführen, das durch den ersten Amplituden- und Phasenmodulator ausgegeben wird;
der erste Verstärker dazu konfiguriert ist, eine Leistungsverstärkung an einem durch den ersten Digital-Analog-Wandler ausgegebenen Signal durchzuführen;
der Bandpassfilter dazu konfiguriert ist, eine Bandpassfilterung an einem durch den ersten Verstärker ausgegebenen Signal durchzuführen, um das zweite analoge Signal zu erlangen; und
der erste Kombinierer ferner mit der Signalverstärkungs-Teilschaltung verbunden ist und der erste Kombinierer dazu konfiguriert ist, das zweite analoge Signal und das erste analoge Signal zu koppeln, um das erste verzerrte Signal zu erlangen.

4. Signalverstärkungsschaltung nach Anspruch **3,** wobei die erste Signalextraktions-Teilschaltung ferner eine nichtlineare Signalanalogvorrichtung und einen zweiten Digital-Analog-Wandler umfasst, wobei
die nichtlineare Signalanalogvorrichtung dazu konfiguriert ist, basierend auf dem ersten digitalen Signal ein nichtlineares Signal zu erzeugen;
der zweite Digital-Analog-Wandler separat mit der nichtlinearen Signalanalogvorrichtung und dem ersten Kombinierer verbunden ist und der zweite Digital-Analog-Wandler dazu konfiguriert ist, eine Digital-Analog-Wandlung des nichtlinearen Signals durchzuführen; und
der erste Kombinierer dazu konfiguriert ist, das zweite analoge Signal, das erste analoge Signal und ein durch die Digital-Analog-Wandlung erlangtes nichtlineares Signal zu koppeln, um das erste verzerrte Signal zu erlangen.

5. Signalverstärkungsschaltung nach einem der Ansprüche 1 bis **4,** wobei die zweite Signalextraktions-Teilschaltung einen zweiten Amplituden- und Phasenmodulator, einen Analog-Digital-Wandler und einen zweiten Kombinierer umfasst, wobei
der zweite Amplituden- und Phasenmodulator dazu konfiguriert ist, eine Amplitudenmodulation und/oder eine Phasenmodulation an dem ersten digitalen Signal durchzuführen;
der Analog-Digital-Wandler mit der ersten Signalextraktions-Teilschaltung verbunden ist und der Analog-Digital-Wandler dazu konfiguriert ist, eine Analog-Digital-Wandlung des ersten verzerrten Signals durchzuführen; und
der zweite Kombinierer separat mit dem zweiten Amplituden- und Phasenmodulator und dem Analog-Digital-Wandler verbunden ist, und der zweite Kombinierer dazu konfiguriert ist, ein erstes verzerrtes Signal, das durch die Analog-Digital-Wandlung erlangt wird, und ein amplitudenmoduliertes und/oder phasenmoduliertes erstes digitales Signal zu koppeln, um das zweite verzerrte Signal zu erlangen.

6. Signalverstärkungsschaltung nach Anspruch 5, wobei die Signalverstärkungsschaltung ferner einen ersten Signalprozessor umfasst, der separat mit dem zweiten Kombinierer und dem zweiten Amplituden- und Phasenmodulator verbunden ist, wobei
der erste Signalprozessor dazu konfiguriert ist, einen Amplituden- und Phasenmodulationsparameter des zweiten Amplituden- und Phasenmodulators basierend auf einem Fehler zwischen dem zweiten verzerrten Signal und dem ersten digitalen Signal einzustellen.

7. Signalverstärkungsschaltung nach einem der Ansprüche 1 bis **6,** wobei die Teilschaltung zur Unterdrückung des verzerrten Signals einen dritten Amplituden- und Phasenmodulator, einen dritten Digital-Analog-Wandler, einen zweiten Verstärker, einen dritten Kombinierer und einen Verzögerer umfasst, die sequenziell verbunden sind, wobei
der dritte Amplituden- und Phasenmodulator ferner mit der zweiten Signalextraktions-Teilschaltung verbunden ist und der dritte Amplituden- und Phasenmodulator dazu konfiguriert ist, eine Amplitudenmodulation und/oder Phasenmodulation an dem zweiten verzerrten Signal durchzuführen;
der dritte Digital-Analog-Wandler dazu konfiguriert ist, eine Digital-Analog-Wandlung an einem amplitudenmodulierten und/oder phasenmodulierten zweiten verzerrten Signal durchzuführen, das durch den dritten Amplituden- und Phasenmodulator ausgegeben wird, um das dritte verzerrte Signal zu erlangen;
der zweite Verstärker dazu konfiguriert ist, eine Leistungsverstärkung des dritten verzerrten Signals durchzuführen;
der Verzögerer ferner mit der Signalverstärkungs-Teilschaltung verbunden ist und der Verzögerer dazu konfiguriert ist, das erste analoge Signal zu verzögern und danach das erste analoge Signal an den dritten Kombinierer zu übertragen; und
der dritte Kombinierer dazu konfiguriert ist, ein leistungsverstärktes drittes verzerrtes Signal und das erste analoge Signal zu koppeln, um das Ausgabesignal zu erlangen.

8. Signalverstärkungsschaltung nach Anspruch 7, wobei die Teilschaltung zur Unterdrückung des verzerrten Signals ferner einen Isolator umfasst, der separat mit dem zweiten Verstärker und dem dritten Kombinierer verbunden ist, wobei
der Isolator dazu konfiguriert ist, ein durch den dritten Kombinierer an den zweiten Verstärker übertragenes Signal zu isolieren.

9. Signalverstärkungsschaltung nach Anspruch 7 oder 8, wobei die Signalverstärkungsschaltung ferner einen zweiten Signalprozessor umfasst, der separat mit dem dritten Kombinierer und dem dritten Amplituden- und Phasenmodulator verbunden ist, wobei
der zweite Signalprozessor dazu konfiguriert ist, einen Amplituden- und Phasenmodulationsparameter des dritten Amplituden- und Phasenmodulators basierend auf einem Fehler zwischen dem Ausgabesignal und dem ersten digitalen Signal einzustellen.

10. Signalverstärkungsverfahren, wobei das Verfahren Folgendes umfasst:
Durchführen einer Digital-Analog-Wandlung und Leistungsverstärkung an einem ersten digitalen Signal, um ein erstes analoges Signal zu erlangen;
Durchführen einer Amplitudenmodulation und/oder einer Phasenmodulation an dem ersten digitalen Signal und Durchführen einer Digital-Analog-Wandlung an einem amplitudenmodulierten und/oder phasenmodulierten ersten digitalen Signal, um ein zweites analoges Signal zu erlangen;
Koppeln des zweiten analogen Signals und des ersten analogen Signals, um ein erstes verzerrtes Signal zu erlangen;
Durchführen einer Analog-Digital-Wandlung des ersten verzerrten Signals;
Koppeln eines durch die Analog-Digital-Wandlung erlangten ersten verzerrten Signals und eines amplitudenmodulierten und/oder phasenmodulierten ersten digitalen Signals, um ein zweites verzerrtes Signal zu erlangen;
Durchführen einer Digital-Analog-Wandlung des zweiten verzerrten Signals, um ein drittes verzerrtes Signal zu erlangen; und
Koppeln des dritten verzerrten Signals und des ersten analogen Signals, um ein Ausgabesignal zu erlangen.

11. Verfahren nach Anspruch 10, wobei das Durchführen einer Analog-Digital-Wandlung an dem amplitudenmodulierten und/oder phasenmodulierten ersten digitalen Signal, um ein zweites analoges Signal zu erlangen, Folgendes umfasst:
sequenzielles Durchführen einer Digital-Analog-Wandlung, einer Leistungsverstärkung und einer Bandpassfilterung an dem amplitudenmodulierten und/oder phasenmodulierten ersten digitalen Signal, um das zweite analoge Signal zu erlangen, wobei
ein Filterdurchlassbereich der Bandpassfilterung größer oder gleich einem Betriebsfrequenzband des Ausgabesignals **ist.**

12. Verfahren nach Anspruch 10 oder 11, wobei das Verfahren ferner Folgendes umfasst:
Erzeugen eines nichtlinearen Signals basierend auf dem ersten digitalen Signal; und
Durchführen einer Digital-Analog-Wandlung an dem nichtlinearen Signal, wobei
das Koppeln des zweiten analogen Signals und des ersten analogen Signals, um ein erstes verzerrtes Signal zu erlange, Folgendes umfasst:
Koppeln des zweiten analogen Signals, des ersten analogen Signals und eines durch die Digital-Analog-Wandlung erlangten nichtlinearen Signals, um das erste verzerrte Signal zu erlangen.

13. Verfahren nach einem der Ansprüche 10 bis 12, wobei das Verfahren ferner Folgendes umfasst:
Einstellen, basierend auf einem Fehler zwischen dem zweiten verzerrten Signal und dem ersten digitalen Signal, eines Amplituden- und Phasenmodulationsparameters, der verwendet wird, wenn eine Amplitudenmodulation und/oder eine Phasenmodulation an dem ersten digitalen Signal durchgeführt wird.

14. Verfahren nach eine der Ansprüche 10 bis 13, wobei das Durchführen einer Digital-Analog-Wandlung des zweiten verzerrten Signals, um ein drittes verzerrtes Signal zu erlangen, Folgendes umfasst:
Durchführen einer Amplitudenmodulation und/oder einer Phasenmodulation an dem zweiten verzerrten Signal; und
Durchführen einer Digital-Analog-Wandlung an einem amplitudenmodulierten und/oder phasenmodulierten zweiten verzerrten Signal, um das dritte verzerrte Signal zu erlangen, wobei
das Koppeln des dritten verzerrten Signals und des ersten analogen Signals, um ein Ausgabesignal zu erlangen, Folgendes umfasst:
Durchführen einer Leistungsverstärkung an dem dritten verzerrten Signal;
Verzögern des ersten analogen Signals; und
Koppeln eines leistungsverstärkten dritten verzerrten Signals und des verzögerten ersten analogen Signals, um das Ausgabesignal zu erlangen.

15. Signalsender, wobei der Signalsender eine Signalerzeugungsschaltung und die Signalverstärkungsschaltung nach einem der Ansprüche 1 bis 9 umfasst, wobei
die Signalerzeugungsschaltung mit der Signalverstärkungsschaltung verbunden ist und die Signalerzeugungsschaltung dazu konfiguriert ist, ein erstes digitales Signal an die Signalverstärkungsschaltung zu übertragen.

## Revendications

1. Circuit d'amplification de signal, dans lequel le circuit d'amplification de signal comprend un sous-circuit d'amplification de signal, un premier sous-circuit d'extraction de signal, un second sous-circuit d'extraction de signal, et un sous-circuit d'annulation de signal déformé, dans lequel
le sous-circuit d'amplification de signal est configuré pour réaliser une conversion numérique-analogique et une amplification de puissance sur un premier signal numérique pour obtenir un premier signal analogique ;
le premier sous-circuit d'extraction de signal est configuré pour : réaliser une modulation d'amplitude et/ou une modulation de phase sur le premier signal numérique, réaliser une conversion numérique-analogique sur un premier signal numérique modulé en amplitude et/ou modulé en phase pour obtenir un second signal analogique, et coupler le second signal analogique et le premier signal analogique pour obtenir un premier signal déformé ;
le second sous-circuit d'extraction de signal est configuré pour : réaliser une conversion analogique-numérique sur le premier signal déformé, réaliser une modulation d'amplitude et/ou une modulation de phase sur le premier signal numérique, et coupler un premier signal déformé obtenu à travers la conversion analogique-numérique et un premier signal numérique modulé en amplitude et/ou modulé en phase pour obtenir un deuxième signal déformé ; et
le sous-circuit **d'annulation** de signal déformé est configuré pour : réaliser une conversion numérique-analogique sur le deuxième signal déformé pour obtenir un troisième signal déformé, et coupler le troisième signal déformé et le premier signal analogique pour obtenir un signal de sortie.

2. Circuit d'amplification de signal selon la revendication 1, dans lequel le premier sous-circuit d'extraction de signal est configuré pour réaliser séquentiellement une conversion numérique-analogique, une amplification de puissance, et un filtrage passe-bande sur le premier signal numérique modulé en amplitude et/ou modulé en phase pour obtenir le second signal analogique, dans lequel
une bande passante de filtrage du filtrage passe-bande est supérieure ou égale à une bande de fréquence de fonctionnement du signal de sortie.

3. Circuit d'amplification de signal selon la revendication 2, dans lequel le premier sous-circuit d'extraction de signal comprend un premier modulateur d'amplitude et de phase, un premier convertisseur numérique-analogique, un premier amplificateur, un filtre passe-bande, et un premier combinateur qui sont connectés séquentiellement, dans lequel
le premier modulateur d'amplitude et de phase est configuré pour réaliser une modulation d'amplitude et/ou une modulation de phase sur le premier signal numérique ;
le premier convertisseur numérique-analogique est configuré pour réaliser une conversion numérique-analogique sur un premier signal numérique modulé en amplitude et/ou modulé en phase émis par le premier modulateur d'amplitude et de phase ;
le premier amplificateur est configuré pour réaliser une amplification de puissance sur un signal émis par le premier convertisseur numérique-analogique ;
le filtre passe-bande est configuré pour réaliser un filtrage passe-bande sur un signal émis par le premier amplificateur pour obtenir le second signal analogique ; et
le premier combinateur est également connecté au sous-circuit d'amplification de signal, et le premier combinateur est configuré pour coupler le second signal analogique et le premier signal analogique pour obtenir le premier signal déformé.

4. Circuit d'amplification de signal selon la revendication 3, dans lequel le premier sous-circuit d'extraction de signal comprend également un dispositif analogique de signal non linéaire et un deuxième convertisseur numérique-analogique, dans lequel
le dispositif analogique de signal non linéaire est configuré pour générer un signal non linéaire sur la base du premier signal numérique ;
le deuxième convertisseur numérique-analogique est connecté séparément au dispositif analogique de signal non linéaire et au premier combinateur, et le deuxième convertisseur numérique-analogique est configuré pour réaliser une conversion numérique-analogique sur le signal non linéaire ; et
le premier combinateur est configuré pour coupler le second signal analogique, le premier signal analogique, et un signal non linéaire obtenu à travers la conversion numérique-analogique pour obtenir le premier signal déformé.

5. Circuit d'amplification de signal selon l'une quelconque des revendications 1 à 4, dans lequel le second sous-circuit d'extraction de signal comprend un deuxième modulateur d'amplitude et de phase, un convertisseur analogique-numérique, et **un** deuxième combinateur, dans lequel
le deuxième modulateur d'amplitude et de phase est configuré pour réaliser une modulation d'amplitude et/ou une modulation de phase sur le premier signal numérique ;
le convertisseur analogique-numérique est connecté au premier sous-circuit d'extraction de signal, et le convertisseur analogique-numérique est configuré pour réaliser une conversion analogique-numérique sur le premier signal déformé ; et
le deuxième combinateur est connecté séparément au deuxième modulateur d'amplitude et de phase et au convertisseur analogique-numérique, et le deuxième combinateur est configuré pour coupler un premier signal déformé obtenu à travers la conversion analogique-numérique et un premier signal numérique modulé en amplitude et/ou modulé en phase pour obtenir le deuxième signal déformé.

6. Circuit d'amplification de signal selon la revendication 5, dans lequel le circuit d'amplification de signal comprend également un premier processeur de signal connecté séparément au deuxième combinateur et au deuxième modulateur d'amplitude et de phase, dans lequel
le premier processeur de signal est configuré pour régler un paramètre de modulation d'amplitude et de phase du deuxième modulateur d'amplitude et de phase sur la base d'une erreur entre le deuxième signal déformé et le premier signal numérique.

7. Circuit d'amplification de signal selon l'une quelconque des revendications 1 à 6, dans lequel le sous-circuit d'annulation de signal déformé comprend un troisième modulateur d'amplitude et de phase, un troisième convertisseur numérique-analogique, un second amplificateur, un troisième combinateur, et un retardateur qui sont connectés séquentiellement, dans lequel
le troisième modulateur d'amplitude et de phase est également connecté au second sous-circuit d'extraction de signal, et le troisième modulateur d'amplitude et de phase est configuré pour réaliser une modulation d'amplitude et/ou une modulation de phase sur le deuxième signal déformé ;
le troisième convertisseur numérique-analogique est configuré pour réaliser une conversion numérique-analogique sur un deuxième signal déformé modulé en amplitude et/ou modulé en phase émis par le troisième modulateur d'amplitude et de phase pour obtenir le troisième signal déformé ;
le second amplificateur est configuré pour réaliser une amplification de puissance sur le troisième signal déformé ;
le retardateur est également connecté au sous-circuit d'amplification de signal, et le retardateur est configuré pour retarder le premier signal analogique puis transmettre le premier signal analogique au troisième combinateur ; et
le troisième combinateur est configuré pour coupler un troisième signal déformé amplifié en puissance et le premier signal analogique pour obtenir le signal de sortie.

8. Circuit d'amplification de signal selon la revendication **7,** dans lequel le sous-circuit d'annulation de signal déformé comprend également un isolateur connecté séparément au second amplificateur et au troisième combinateur, dans lequel
l'isolateur est configuré pour isoler un signal transmis du troisième combinateur au second amplificateur.

9. Circuit d'amplification de signal selon la revendication 7 **ou 8,** dans lequel le circuit d'amplification de signal comprend également un second processeur de signal connecté séparément au troisième combinateur et au deuxième modulateur d'amplitude et de phase, dans lequel
le second processeur de signal est configuré pour régler un paramètre de modulation **d'amplitude** et de phase du troisième modulateur **d'amplitude** et de phase sur la base **d'une** erreur entre le signal de sortie et le premier signal numérique.

10. Procédé d'amplification de signal, dans lequel le procédé comprend :
la réalisation d'une conversion numérique-analogique et d'une amplification de puissance sur un premier signal numérique pour obtenir un premier signal analogique ;
la réalisation d'une modulation d'amplitude et/ou d'une modulation de phase sur le premier signal numérique, et la réalisation d'une conversion numérique-analogique sur un premier signal numérique modulé en amplitude et/ou en modulé en phase pour obtenir un second signal analogique ;
le couplage du second signal analogique et du premier signal analogique pour obtenir un premier signal déformé ;
la réalisation d'une conversion analogique-numérique sur le premier signal déformé ;
le couplage d'un premier signal déformé obtenu à travers la conversion analogique-numérique et d'un premier signal numérique modulé en amplitude et/ou modulé en phase pour obtenir un deuxième signal déformé ;
la réalisation d'une conversion numérique-analogique sur le deuxième signal déformé pour obtenir un troisième signal déformé ; et
le couplage du troisième signal déformé et du premier signal analogique pour obtenir un signal de sortie.

11. Procédé selon la revendication 10, dans lequel la réalisation d'une conversion numérique-analogique sur un premier signal numérique modulé en amplitude et/ou modulé en phase pour obtenir un second signal analogique comprend :
la réalisation séquentielle d'une conversion numérique-analogique, d'une amplification de puissance, et d'un filtrage passe-bande sur le premier signal numérique modulé en amplitude et/ou modulé en phase pour obtenir le second signal analogique, dans lequel
une bande passante de filtrage du filtrage passe-bande est supérieure ou égale à une bande de fréquence de fonctionnement du signal de sortie.

12. Procédé selon la revendication 10 ou 11, dans lequel le procédé comprend également :
la génération d'un signal non linéaire sur la base du premier signal numérique ; et
la réalisation d'une conversion numérique-analogique sur le signal non linéaire, dans lequel
le couplage du second signal analogique et du premier signal analogique pour obtenir un premier signal déformé comprend :
le couplage du second signal analogique, du premier signal analogique, et d'un signal non linéaire obtenu à travers la conversion numérique-analogique pour obtenir le premier signal déformé.

13. Procédé selon l'une quelconque des revendications 10 à 12, dans lequel le procédé comprend également :
le réglage, sur la base d'une erreur entre le deuxième signal déformé et le premier signal numérique, d'un paramètre de modulation d'amplitude et de phase utilisé lorsque la modulation d'amplitude et/ou la modulation de phase est réalisée sur le premier signal numérique.

14. Procédé selon l'une quelconque des revendications 10 à 13, dans lequel la réalisation d'une conversion numérique-analogique sur le deuxième signal déformé pour obtenir un troisième signal déformé comprend :
la réalisation d'une modulation d'amplitude et/ou d'une modulation de phase sur le deuxième signal déformé ; et
la réalisation d'une conversion numérique-analogique sur un deuxième signal déformé modulé en amplitude et/ou modulé en phase pour obtenir le troisième signal déformé, dans lequel
le couplage du troisième signal déformé et du premier signal analogique pour obtenir un signal de sortie comprend :
la réalisation d'une amplification de puissance sur le troisième signal déformé ;
le retardement du premier signal analogique ; et
le couplage d'un troisième signal déformé amplifié en puissance et du premier signal analogique retardé pour obtenir le signal de sortie.

15. Émetteur de signal, dans lequel l'émetteur de signal comprend un circuit de génération de signal et le circuit d'amplification de signal selon l'une quelconque des revendications 1 à 9, dans lequel
le circuit de génération de signal est connecté au circuit d'amplification de signal, et le circuit de génération de signal est configuré pour transmettre un premier signal numérique au circuit d'amplification de signal.
